# EUROPEAN PATENT APPLICATION

(11) **EP 4 651 691 A1**
(43) Date of publication of application: **19.11.2025**
(21) Application number: 24806271.3
(22) Date of filing: 17.04.2024
(51) Int. Cl.: H10K 59/123

(54) **DISPLAY PANEL AND DISPLAY DEVICE**

(30) Priority: 17.05.2023 CN 202310560787
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: XIAO, Bangqing, Beijing 100176 (CN); WANG, Benlian, Beijing 100176 (CN); ZHENG, Hai, Beijing 100176 (CN); HU, Ming, Beijing 100176 (CN)
(74) Representative: Hoffmann Eitle
(86) International application number: PCT/CN2024/088432
(87) International publication number: WO 2024/234914

(57) **Abstract**

A display panel, comprising a primary display area and a secondary display area, the primary display area at least partially surrounding the secondary display area. The display panel comprises a substrate, a plurality of light-emitting devices and a plurality of conductive layers; the plurality of light-emitting devices are located on one side of the substrate, and the plurality of conductive layers are stacked between the substrate and the plurality of light-emitting devices. The plurality of light-emitting devices comprise a plurality of first light-emitting devices, and the plurality of conductive layers comprise a plurality of connection wiring groups. The first light-emitting devices are located in the secondary display area, and the first light-emitting devices are electrically connected to pixel circuits located in a first primary display area by means of the connection wiring groups. The plurality of conductive layers further comprise a plurality of compensation wiring groups. The number of the pixel circuits through which connection wirings in an a-th connection wiring group pass in a first direction is less than or equal to the number of the pixel circuits through which compensation wirings in an a-th compensation wiring group pass in the first direction, wherein a is any positive integer between 1 and n. The display panel provided by embodiments of the present disclosure can be used for the display device.

## Description

This application claims priority to Chinese Patent Application No. 202310560787.6, filed with the China National Intellectual Property Administration on May 17, 2023, titled "DISPLAY PANEL AND DISPLAY APPARATUS", which is incorporated herein by reference in its entirety.

### TECHNICAL FIELD

The present disclosure relates to the field of display technologies, and in particular, to a display panel and a display apparatus.

### BACKGROUND

A display panel may include a main display region and a secondary display region, and optical components (e.g., a camera) may be located within the secondary display region. Light-emitting devices located in the secondary display region may be electrically connected to pixel circuits located in the main display region through connecting lines, so that the pixel circuits may drive the light-emitting devices located in the secondary display region to emit light, thereby enabling the display panel to achieve full display with camera (FDC).

### SUMMARY

In an aspect, a display panel is provided. The display panel includes a display region. The display region includes a main display region and a secondary display region; the main display region at least partially surrounds the secondary display region, and the main display region includes a first main display region and a second main display region; the first main display region is located on both sides of the secondary display region along a first direction, and the second main display region is located on at least one side of the secondary display region along a second direction; the first direction intersects with the second direction. The display panel includes a substrate, a plurality of light-emitting devices, and a plurality of conductive layers. The plurality of light-emitting devices are located on a side of the substrate, and the plurality of light-emitting devices include a plurality of first light-emitting devices located in the secondary display region. The plurality of conductive layers are stacked between the substrate and the plurality of light-emitting devices. The plurality of conductive layers include a plurality of pixel circuits, a plurality of connecting line groups and a plurality of compensation line groups. The plurality of pixel circuits are located in the main display region; the plurality of pixel circuits are arranged in multiple columns along the first direction, and the plurality of pixel circuits are arranged in multiple rows along the second direction; at least one column of the multiple columns of pixel circuits includes first driving pixel circuits located in the first main display region. The plurality of connecting line groups are arranged at intervals along the second direction; at least one of the plurality of connecting line groups includes at least two connecting lines, and the at least two connecting lines are arranged at intervals along the first direction and extend along the first direction; a first end of each of the at least two connecting lines is located in the secondary display region and is electrically connected to a first light-emitting device, and a second end of each of the at least two connecting lines extends to the first main display region and is electrically connected to a first driving pixel circuit. A number of the connecting line groups is n, and the n connecting line groups include a first connecting line group, a second connecting line group, ..., and an n-th connecting line group. The plurality of compensation line groups are arranged at intervals along the second direction; at least one of the plurality of compensation line groups includes at least one compensation line; the at least one compensation line extends along the first direction, and the at least one compensation line is configured to be electrically connected to a constant voltage signal. The plurality of compensation line groups constitute compensation units, and the compensation units include first compensation units; a first compensation unit includes a first compensation line group, a second compensation line group, ..., and an n-th compensation line group. A number of pixel circuits through which connecting lines in an a-th connecting line group pass along the first direction is less than or equal to a number of pixel circuits through which compensation lines in an a-th compensation line group pass along the first direction; n is a positive integer, and a is any positive integer between 1 and n.

In some embodiments, the second main display region includes a plurality of first sub-regions; the plurality of first sub-regions are adjacently arranged along the second direction, and a first sub-region is arranged adjacent to the first main display region along the second direction. A number of the compensation line groups is greater than the number of the connecting line groups, and at least one first compensation unit is located in a same first sub-region.

In some embodiments, the first main display region includes a second sub-region and a third sub-region, the second sub-region is located on a side of the secondary display region along the first direction, and the third sub-region is located on a side of the secondary display region away from the second sub-region along the first direction. The at least one connecting line group includes first connecting line(s) and second connecting line(s); a second end of a first connecting line is located in the second sub-region, and a second end of a second connecting line is located in the third sub-region.

In some embodiments, the at least one compensation line group includes a first compensation line and a second compensation line, and the first compensation line and the second compensation line are arranged at intervals along the first direction. A number of pixel circuits through which the first connecting line in the a-th connecting line group passes along the first direction is the same as a number of pixel circuits through which the first compensation line in the a-th compensation line group passes along the first direction; and a number of pixel circuits through which the second connecting line in the a-th connecting line group passes along the first direction is the same as a number of pixel circuits through which the second compensation line in the a-th compensation line group pass along the first direction.

In some embodiments, an arrangement position of the first connecting line in the a-th connecting line group along the first direction is at least partially aligned with an arrangement position of the first compensation line in the a-th compensation line group along the first direction; and/or an arrangement position of the second connecting line in the a-th connecting line group along the first direction is at least partially aligned with an arrangement position of the second compensation line in the a-th compensation line group along the first direction.

In some embodiments, a plurality of first compensation lines located in the same first sub-region are arranged at intervals along the first direction; and/or a plurality of second compensation lines located in the same first sub-region are arranged at intervals along the first direction.

In some embodiments, in the case where the plurality of first compensation lines located in the same first sub-region are arranged at intervals along the first direction, first ends or second ends of the plurality of first compensation lines located in the same first sub-region have same intervals along the first direction. In the case where the plurality of second compensation lines located in the same first sub-region are arranged at intervals along the first direction, first ends or second ends of the plurality of the second compensation lines located in the same second sub-region have same intervals along the first direction.

In some embodiments, the at least one compensation line group includes one compensation line. An arrangement position of the a-th connecting line group along the first direction is at least partially aligned with an arrangement position of the a-th compensation line group along the first direction.

In some embodiments, the at least one column of pixel circuits further includes redundant pixel circuits located in the second main display region; along the second direction, the redundant pixel circuits and the first driving pixel circuits are arranged in a column; at least one end of the at least one compensation line is electrically connected to a redundant pixel circuit.

In some embodiments, a pixel circuit includes a second light-emitting control transistor and a second reset transistor; a second electrode of the second light-emitting control transistor is electrically connected to a second electrode of the second reset transistor, and a connection node between the second electrode of the second light-emitting control transistor and the second electrode of the second reset transistor is a fourth node; the second end of the connecting line is electrically connected to the fourth node of the first driving circuit. The at least one end of the at least one compensation line is electrically connected to the fourth node of the redundant pixel circuit.

In some embodiments, the redundant pixel circuits and the first driving pixel circuits are arranged to form a first column of pixel circuits; the plurality of pixel circuits further include second driving pixel circuits, and the second driving pixel circuits are arranged to form a second column of pixel circuits along the second direction; the first column of pixel circuits and the second column of pixel circuits are alternately arranged along the first direction. The plurality of light-emitting devices further include second light-emitting devices, and the second light-emitting devices are located in the main display region and electrically connected to the second driving pixel circuits.

In some embodiments, the display panel further includes a peripheral region, and the peripheral region at least partially surrounds the display region. The display panel further includes a second voltage signal line, and the second voltage signal line is located in the peripheral region. At least one end of the at least one compensation line extends to the peripheral region and is electrically connected to the second voltage signal line.

In some embodiments, the second voltage signal line is located at least on both sides of the display region along the first direction. An end of the at least one compensation line is located on a side of the display region along the first direction and is electrically connected to the second voltage signal line located in the peripheral region, and another end of the at least one compensation line is located on another side of the display region along the first direction and is electrically connected to the second voltage signal line located in the peripheral region.

In some embodiments, a shape of line segments of the at least one compensation line located in the first sub-region includes at least one of a straight shape and a wavy shape.

In some embodiments, the secondary display region includes a center line extending through a center of the secondary display region along the second direction. The plurality of first light-emitting devices include a plurality of first first light-emitting devices and a plurality of second first light-emitting devices, and the plurality of first first light-emitting devices and the plurality of second first light-emitting devices are located on both sides of the center line of the secondary display region along the first direction. A plurality of first connecting lines are electrically connected to the plurality of first first light-emitting devices in a one-to-one correspondence, and a plurality of second connecting lines are electrically connected to the plurality of second first light-emitting devices in a one-to-one correspondence.

In some embodiments, the first connecting line(s) include a first first connecting line and a second first connecting line; a distance between a first end of the first first connecting line and an edge of the secondary display region is greater than a distance between a first end of the second first connecting line and the edge of the secondary display region; and a distance between a second end of the first first connecting line and the edge of the secondary display region is greater than a distance between a second end of the second first connecting line and the edge of the secondary display region. The second connecting line(s) include a first second connecting line and a second second connecting line; a distance between a first end of the first second connecting line and the edge of the secondary display region is greater than a distance between a first end of the second second connecting line and the edge of the secondary display region; and a distance between a second end of the first second connecting line and the edge of the secondary display region is greater than a distance between a second end of the second second connecting line and the edge of the secondary display region.

In some embodiments, the compensation units further include a second compensation unit, and the second compensation unit includes m compensation line groups. m is a positive integer, and m is less than n. Along the second direction, the second compensation unit is adjacent to an edge of the display panel.

In some embodiments, the second main display region is located on both sides of the secondary display region along the second direction.

In some embodiments, the plurality of connecting line groups and the plurality of compensation line groups are located in a same conductive layer.

In another aspect, a display panel is provided. The display panel includes a display region. The display region includes a main display region and a secondary display region; the main display region at least partially surrounds the secondary display region, and the main display region includes a first main display region and a second main display region; the first main display region is located on both sides of the secondary display region along a first direction, and the second main display region is located on at least one side of the secondary display region along a second direction; the first direction intersects with the second direction. The display panel includes a substrate, a plurality of light-emitting devices, and a plurality of conductive layers. The plurality of light-emitting devices are located on a side of the substrate, and the plurality of light-emitting devices include a plurality of first light-emitting devices located in the secondary display region. The plurality of conductive layers are stacked between the substrate and the plurality of light-emitting devices. The plurality of conductive layers include a plurality of pixel circuits, a plurality of connecting line groups and a plurality of compensation line groups. The plurality of pixel circuits are located in the main display region; the plurality of pixel circuits are arranged in multiple columns along the first direction, and the plurality of pixel circuits are arranged in multiple rows along the second direction; at least one column of the multiple columns of pixel circuits includes first driving pixel circuits located in the first main display region. The plurality of connecting line groups are arranged at intervals along the second direction; at least one of the plurality of connecting line groups includes at least two connecting lines, and the at least two connecting lines are arranged at intervals along the first direction and extend along the first direction. A first end of each of the at least two connecting lines is located in the secondary display region and is electrically connected to a first light-emitting device, and a second end of each of the at least two connecting lines extends to the first main display region and is electrically connected to a first driving pixel circuit. A number of the connecting line groups is n, and the n connecting line groups include a first connecting line group, a second connecting line group, ..., and an n-th connecting line group. The plurality of compensation line groups are arranged at intervals along the second direction; at least one of the plurality of compensation line groups includes at least one compensation line; the at least one compensation line extends along the first direction, and the at least one compensation line is configured to be electrically connected to a constant voltage signal. The plurality of compensation line groups constitute a compensation unit, and the compensation unit includes a first compensation unit; the first compensation unit includes a first compensation line group, a second compensation line group, ..., and an n-th compensation line group. An overlapping area between pixel circuits through which a connecting line in an a-th connecting line group passes along the first direction and the connecting line in the a-th connecting line group is less than or equal to an overlapping area between pixel circuits through which a compensation line in an a-th compensation line group passes along the first direction and the compensation line in the a-th compensation line group; n is a positive integer, and a is any positive integer between 1 and n.

In some embodiments, the first main display region includes a second sub-region and a third sub-region, the second sub-region is located on a side of the secondary display region along the first direction, and the third sub-region is located on a side of the secondary display region away from the second sub-region along the first direction. The at least one connecting line group includes a first connecting line and a second connecting line; a second end of the first connecting line is located in the second sub-region, and a second end of the second connecting line is located in the third sub-region.

In some embodiments, the at least one compensation line group includes a first compensation line and a second compensation line, and the first compensation line and the second compensation line are arranged at intervals along the first direction. An overlapping area between pixel circuits through which the first connecting line in the a-th connecting line group passes along the first direction and the first connecting line in the a-th connecting line group is the same as an overlapping area between pixel circuits through which the first compensation line in the a-th compensation line group passes along the first direction and the first compensation line in the a-th compensation line group. An overlapping area between pixel circuits through which the second connecting line in the a-th connecting line group passes along the first direction and the second connecting line in the a-th connecting line group is the same as an overlapping area between pixel circuits through which the second compensation line in the a-th compensation line group passes along the first direction and the second compensation line in the a-th compensation line group.

In yet another aspect, a display apparatus is provided. The display apparatus includes the above-mentioned display panel.

The display panel and the display apparatus provided by the present disclosure have at least the following beneficial effects.

In the embodiments of the present disclosure, by providing the plurality of connecting line groups, the plurality of first light-emitting devices located in the secondary display region may be electrically connected to the plurality of first driving pixel circuits located in the first main display region, so that the first driving pixel circuits may drive the first light-emitting devices to emit light.

In addition, the plurality of conductive layers include the plurality of compensation line groups, and the plurality of compensation line groups are arranged at intervals along the second direction, and the compensation line in the compensation line group extends along the first direction, so that the arrangement of the compensation line group can be the same as the arrangement of the connecting line group, and the extending direction of the compensation line can be the same as the extending direction of the connecting line.

The compensation line is electrically connected to the constant voltage signal, so that the compensation line can be coupled to the pixel circuit (e.g., the redundant pixel circuit or the second driving pixel circuit) located in the second main display region. A number of compensation line groups in the first compensation unit is the same as a number of connecting line groups (both are n), and the number of pixel circuits through which the connecting lines in the a-th connecting line group pass along the first direction may be less than or equal to the number of pixel circuits through which the compensation lines in the a-th compensation line group pass along the first direction, so that the coupling generated between the first compensation unit and the pixel circuits in the second main display region may be the same or substantially the same as the coupling generated between the connecting line group and the pixel circuits located in the first main display region. In this way, the first compensation unit is capable of reducing the difference between the loading of the pixel circuit located in the second main display region and the loading of the pixel circuit located in the first main display region, so as to improve the horizontal hole mura of the display panel, and improve the brightness uniformity of different positions of the display panel, thereby improving the display performance of the display panel.

### BRIEF DESCRIPTION OF THE DRAWINGS

In order to describe technical solutions in some embodiments of the present disclosure more clearly, the accompanying drawings to be used in some embodiments of the present disclosure will be introduced briefly; obviously, the accompanying drawings to be described below are merely some embodiments of the present disclosure, and a person of ordinary skill in the art can obtain other drawings according to those drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a structural diagram of a display apparatus, in accordance with some embodiments;
FIG. 2 is a structural diagram of a display panel, in accordance with some embodiments;
FIG. 3 is a diagram showing a circuit structure of a pixel circuit, in accordance with some embodiments;
FIG. 4 is a structural diagram of a display apparatus, in accordance with some other embodiments;
FIG. 5 is a structural diagram of a display apparatus, in accordance with yet some other embodiments;
FIG. 6 is a structural diagram of a display panel, in accordance with some other embodiments;
FIG. 7 is a partial structural diagram of a display panel, in accordance with some embodiments;
FIG. 8 is an enlarged partial view of the M1 region in FIG. 7;
FIG. 9 is a structural diagram of a display apparatus, in accordance with yet some other embodiments;
FIG. 10 is a structural diagram of yet another display panel, in accordance with some embodiments;
FIG. 11 is a partial structural diagram of a display panel, in accordance with some other embodiments;
FIG. 12 is an enlarged partial view of the M2 region in FIG. 11;
FIG. 13 is a structural diagram of yet another display panel, in accordance with some embodiments;
FIG. 14 is a partial structural diagram of a display panel, in accordance with yet some other embodiments;
FIG. 15 is a structural diagram of yet another display panel, in accordance with some embodiments;
FIG. 16 is a partial structural diagram of a display panel, in accordance with yet some other embodiments;
FIG. 17 is an enlarged partial view of the M3 region in FIG. 16;
FIG. 18 is a structural diagram of yet another display panel, in accordance with some embodiments;
FIG. 19 is a partial structural diagram of a display panel, in accordance with yet some other embodiments;
FIG. 20 is a structural diagram of yet another display panel, in accordance with some embodiments; and
FIG. 21 is a partial structural diagram of a display panel, in accordance with yet some other embodiments.

### DETAILED DESCRIPTION

The technical solutions in some embodiments of the present disclosure will be described clearly and completely with reference to the accompanying drawings; obviously, the described embodiments are merely some but not all embodiments of the present disclosure. All other embodiments obtained by a person having ordinary skill in the art based on the embodiments of the present disclosure shall be included in the protection scope of the present disclosure.

Unless the context requires otherwise, throughout the description and claims, the term "comprise" and other forms thereof such as the third-person singular form "comprises" and the present participle form "comprising" are construed as an open and inclusive meaning, i.e., "including, but not limited to". In the description of the specification, terms such as "one embodiment", "some embodiments", "exemplary embodiments", "example", "specific example" or "some examples" are intended to indicate that specific features, structures, materials or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics described may be included in any one or more embodiments or examples in any suitable manner.

The terms "first" and "second" are used for descriptive purposes only, and are not to be construed as indicating or implying a relative importance or implicitly indicating the number of indicated technical features. Thus, a feature defined with "first" or "second" may explicitly or implicitly include one or more of the features. In the description of the embodiments of the present disclosure, the term "multiple," "a plurality of" or "the plurality of" means two or more unless otherwise specified.

In the description of some embodiments, the term "coupled" and extensions thereof may be used. For example, the term "coupled" indicates that two or more components are in direct physical or electrical contact. The embodiments disclosed herein are not necessarily limited to the context herein.

The phrase "at least one of A, B and C" has the same meaning as the phrase "at least one of A, B or C", both including following combinations of A, B and C: only A, only B, only C, a combination of A and B, a combination of A and C, a combination of B and C, and a combination of A, B and C.

The phrase "A and/or B" includes following three combinations: only A, only B, and a combination of A and B.

The term such as "about", "substantially" or "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

It will be understood that, in a case where a layer or element is referred to be on another layer or substrate, it may be that the layer or element is directly on the another layer or substrate, or it may be that there is intermediate layer(s) between the layer or element and the another layer or substrate.

Exemplary embodiments are described herein with reference to sectional views and/or plan views as idealized exemplary drawings. In the drawings, thicknesses of layers and sizes of regions are enlarged for clarity. Variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a feature being curved. Therefore, the regions shown in the accompanying drawings are schematic in nature, and their shapes are not intended to show actual shapes of the regions in a device, and are not intended to limit the scope of the exemplary embodiments.

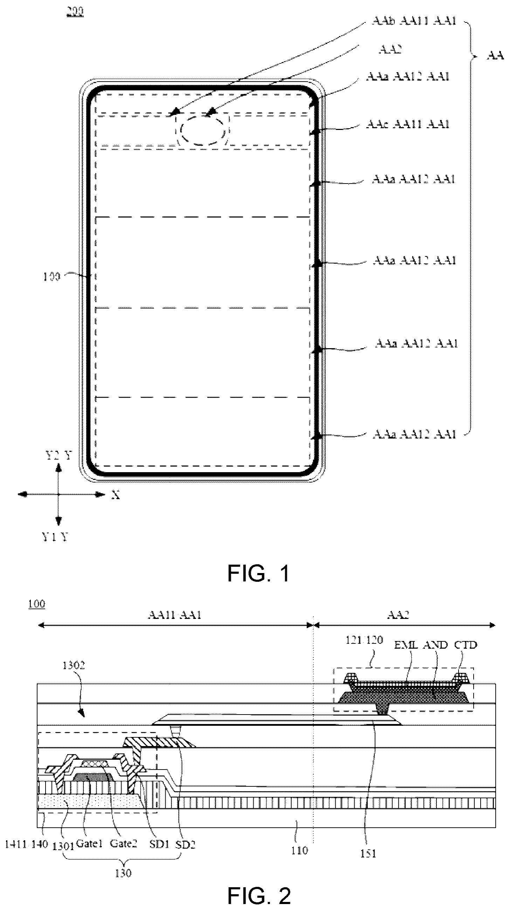

FIG. 1 is a structural diagram of a display apparatus, in accordance with some embodiments.

As shown in FIG. 1, some embodiments of the present disclosure provide a display apparatus 200. It can be understood that the display apparatus 200 is a product having an image display function. For example, the display apparatus 200 may be used to display still images, such as pictures or photos. The display apparatus 200 may also be used to display dynamic images, such as videos or game images.

In some examples, the display apparatus 200 may be a notebook computer, a mobile telephone, a wireless device, a personal digital assistant (PDA), a hand-held or portable computer, a global positioning system (GPS) receiver/navigator, a camera, an MPEG-4 Part 14 (MP4) video player, a video camera, a game console, a watch, a clock, a calculator, a television (TV) monitor, a flat-panel display, a computer monitor, a car display (e.g., an odometer display), a navigator, a cockpit controller and/or display, a camera view display (e.g., a rear view camera display in a vehicle), an electronic photo, an electronic billboard or sign, a projector, a packaging and aesthetic structure (e.g., a display for displaying an image of a piece of jewelry), and the like.

As shown in FIG. 1, the display apparatus 200 may include a display panel 100. In some examples, the display panel 100 may be an organic light-emitting diode (OLED) display panel, a quantum dot light-emitting diode (QLED) display panel, a micro light-emitting diode (Micro LED) display panel or a mini light-emitting diode (Mini LED) display panel, and the embodiments of the present disclosure do not further limit the type of the display panel 100.

In some examples, the display apparatus 200 may further include a frame, a display driver integrated circuit (IC) and other electronic components. The embodiments of the present disclosure do not further limit the other components in the display apparatus 200 other than the display panel 100. The display panel 100 will be exemplarily described below.

For example, as shown in FIG. 1, the display panel 100 may include a display region AA, and the display region AA may include a main display region AA1 and a secondary display region AA2. The main display region AA1 may at least partially surround the secondary display region AA2.

It can be understood that both the main display region AA1 and the secondary display region AA2 may display image information. In some examples, the main display region AA1 may entirely surround the secondary display region AA2 (see FIG. 1). In some other examples, the main display region AA1 may also partially surround the secondary display region AA2. In some examples, an edge of the main display region AA1 proximate to the secondary display region AA2 is adjacent to an edge of the secondary display region AA2.

For example, a shape of the secondary display region AA2 may be quadrilateral, polygon, circle, ellipse, or other irregular shapes. An area of the secondary display region AA2 may be less than that of the main display region AA1. It can be understood that the embodiments of the present disclosure do not further limit the shape and area of the secondary display region AA2.

In some examples, the display panel 100 may include an optical element (not shown in the figures), and the optical element may be located in the secondary display region AA2. For example, the optical element may be disposed proximate to an edge of the secondary display region AA2 (e.g., a top edge), or the optical element may be disposed proximate to a center of the display region AA.

It can be understood that the external light may pass through film layers (e.g., an encapsulation layer or a conductive layer, etc.) of the display panel 100 located in the secondary display region AA2 and irradiate the optical element. The light irradiated on the optical element may be collected by the optical element, so that the optical element is capable of working normally. For example, the optical element may be a camera, a fingerprint recognition sensor, an infrared sensor, or the like.

Taking the optical element as a camera as an example, the external light may pass through the film layers of the display panel 100 located in the secondary display region AA2 and irradiate on the camera. In this way, the camera may acquire the light to realize a photographing function.

For example, in a case where the camera is working (for example, the user is taking a selfie), the secondary display region AA2 may present a black screen, and the main display region AA1 may present the user's selfie screen, which may clearly show the location of the camera. Alternatively, in a case where the camera is working (for example, the user is taking a selfie), the display region AA (including the main display region AA1 and the secondary display region AA2) may present the user's selfie screen as a whole, without showing the location of the camera.

In some examples, as shown in FIG. 1, the secondary display region AA2 may be located in the middle of the display panel 100 along a first direction X. In some other examples, the secondary display region AA2 may also be proximate to an edge of the display panel 100 along the first direction X. In some other examples, the secondary display region AA2 may be located in the middle of the display panel 100 along the second direction Y, or the secondary display region AA2 may be proximate to an edge of the display panel 100 along the second direction Y. The embodiments of the present disclosure do not further limit an arrangement position of the secondary display region AA2.

The first direction X intersects with the second direction Y. For example, the first direction X may be perpendicular to or approximately perpendicular to the second direction Y. In some examples, the first direction X may be a horizontal direction, and the second direction Y may be a vertical direction.

For example, the display panel 100 may include a plurality of sub-pixels (not shown in the figures), and the plurality of sub-pixels may be arranged in an array in the display region AA (including the main display region AA1 and the secondary display region AA2), so that the display panel 100 is capable of achieving full-screen display.

It can be understood that a sub-pixel is a smallest unit for displaying images in the display panel 100, and the sub-pixel may include a light-emitting device 120 and a pixel circuit 140 (see FIG. 2). The pixel circuit 140 is electrically connected to the light-emitting device 120 for driving the light-emitting device 120 to emit light.

Each sub-pixel may display a single color, such as red, green or blue. The display panel 100 may include a plurality of red sub-pixels, a plurality of green sub-pixels and a plurality of blue sub-pixels. By adjusting brightness (gray scales) of sub-pixels of different colors, red light, green light and blue light of different intensities may be obtained. At least two of the red light, the green light and the blue light of different intensities are superimposed, and thus light of more colors may be displayed, thereby realizing full-color display of the display panel 100.

FIG. 2 is a structural diagram of a display panel, in accordance with some embodiments. Hereinafter, the structure of the display panel 100 in some embodiments of the present disclosure will be described exemplarily by taking an example in which the display panel 100 is an OLED display panel with reference to FIG. 2.

In some examples, as shown in FIG. 2, the display panel 100 may include a substrate 110, a plurality of light-emitting devices 120, and a plurality of conductive layers 130. The plurality of light-emitting devices 120 may be located on a side of the substrate 110. The plurality of conductive layer 130 may be stacked between the substrate 110 and the plurality of light-emitting devices 120. The plurality of conductive layers 130 may include a plurality of pixel circuits 140.

It can be understood that, FIG. 2 only shows one light-emitting device 120 and one pixel circuit 140 in order to clearly illustrate the structures in the drawing, and does not further limit the number of light-emitting devices 120 and pixel circuits 140 in the embodiments of the present disclosure.

In some examples, the substrate 110 may be a rigid substrate. The rigid substrate may be, for example, a glass substrate or a polymethyl methacrylate (PMMA) substrate. In this case, the display panel 100 may be a rigid display panel.

In some other examples, the substrate 110 may be a flexible substrate. The flexible substrate may be, for example, a polyethylene terephthalate (PET) substrate, a polyethylene naphthalate two formic acid glycol ester (PEN) substrate, or a polyimide (PI) substrate. In this case, the display panel 100 may be a flexible display panel.

The plurality of light-emitting devices 120 may be arranged in an array on a side of the substrate 110. In some examples, as shown in FIG. 2, the light-emitting device 120 may include an anode layer AND, a light-emitting layer EML and a cathode layer CTD that are sequentially arranged in a direction away from the substrate 110.

The light-emitting layer EML may include a plurality of effective light-emitting portions (not shown in the figures) arranged at intervals, and the light-emitting portion is used for emitting light. The effective light-emitting portion may include an electroluminescent material. It can be understood that the electroluminescence refers to the phenomenon that organic semiconductor materials are driven by an electric field to form excitons through injection of carriers, transport of carriers, and combination of electrons and holes, and then radiative recombination to emit light.

In some examples, the anode layer AND may be made of a metal material, such as copper or silver. The cathode layer CTD may be made of a transparent material, such as indium tin oxide (ITO) or indium zinc oxide (IZO) that is transparent, so that light emitted by the effective light-emitting portions can exit through the cathode layer CTD. In this case, the display panel 100 may be a top-emission display panel.

For example, in consideration of work function, the material of the anode layer AND may include ITO, or a stack of ITO-Ag-ITO, so that the anode layer AND can provide more holes. The material of the cathode layer CTD may include magnesium (Mg) and silver (Ag), so that the cathode layer CTD can provide more electrons. The cathode layer CTD has a small thickness and can transmit light, so that the display panel 100 is capable of realizing top emission.

In some examples, along a direction from the anode layer AND to the effective light-emitting portion, at least one of a hole injection layer (HIL), a hole transport layer (HTL) and an electron blocking layer (EBL) is provided between the anode layer AND and the effective light-emitting portion. Along a direction from the cathode layer CTD to the effective light-emitting portion, at least one of an electron injection layer (EIL), an electron transport layer (ETL) and a hole blocking layer (HBL) is provided between the cathode layer CTD and the effective light-emitting portion. Such an arrangement may improve the light-emitting performance of the effective light-emitting portion.

In some examples, the display panel 100 may further include an encapsulation layer (not shown in the figures). The encapsulation layer is located on a side of the light-emitting device 120 away from the substrate 110, and can cover the light-emitting device 120, so as to wrap the light-emitting device 120, which prevents water vapor and oxygen in an external environment from entering the light-emitting device 120 and protects the light-emitting device 120.

The plurality of conductive layers 130 may be stacked between the substrate 110 and the plurality of light-emitting devices 120. In some examples, insulating layer(s) (such as a gate insulating layer, a buffer layer, a passivation layer, an organic layer, etc.) may be disposed between adjacent two conductive layers 130, so as to electrically isolate the adjacent two conductive layers 130.

For example, as shown in FIG. 2, the plurality of conductive layers 130 may include an active layer 1301, a first gate metal layer Gate1, a second gate metal layer Gate2, a first source-drain metal layer SD1, and a second source-drain metal layer SD2 arranged in sequence along a direction away from the substrate 110.

It will be noted that the number of active layers 1301 is not limited here. For example, in some embodiments of the present disclosure, the plurality of conductive layers 130 may only include one active layer 1301, and a material of the active layer 1301 may include a metal oxide or a low temperature polysilicon. Alternatively, in some embodiments of the present disclosure, the plurality of conductive layers 130 may further include two active layers 1301, a material of one active layer 1301 may include a metal oxide, and a material of another active layer may include a low temperature polysilicon.

In some examples, the plurality of conductive layers 130 may further include a third gate metal layer (not shown in the figures). In this case, the first gate metal layer Gate1, the second gate metal layer Gate2, the third gate metal layer, the first source-drain metal layer SD1, and the second source-drain metal layer SD2 may be stacked in sequence in a direction away from the substrate 110.

It can be understood that the plurality of conductive layers 130 includes the plurality of pixel circuits 140, that is, the plurality of pixel circuits 140 may be disposed in the plurality of conductive layers 130. In some examples, the pixel circuit 140 may be electrically connected to an anode of the light-emitting device 120.

In some examples, the pixel circuit 140 may include a plurality of transistors and at least one storage capacitor. For example, the pixel circuit 140 may be a structure such as "2T1C," "6T1C," "7T1C," "6T2C," or "7T2C". Here, "T" represents a transistor, a number before "T" represents the number of transistors, "C" represents a storage capacitor, and a number before "C" represents the number of storage capacitors.

For example, the transistors may be thin film transistors (TFTs), metal oxide semiconductor (MOS) transistors, or other switching devices with same characteristics.

In some examples, the active layer 1301 and the first gate metal layer Gate1 may be used to form a part of transistors (one, two or more transistors) among the plurality of transistors, and the active layer 1301 and the second gate metal layer Gate2 may be used to form another part of transistors (one, two or more transistors) among the plurality of transistors. The first gate metal layer Gate1 and the second gate metal layer Gate2 may be used to form the at least one storage capacitor.

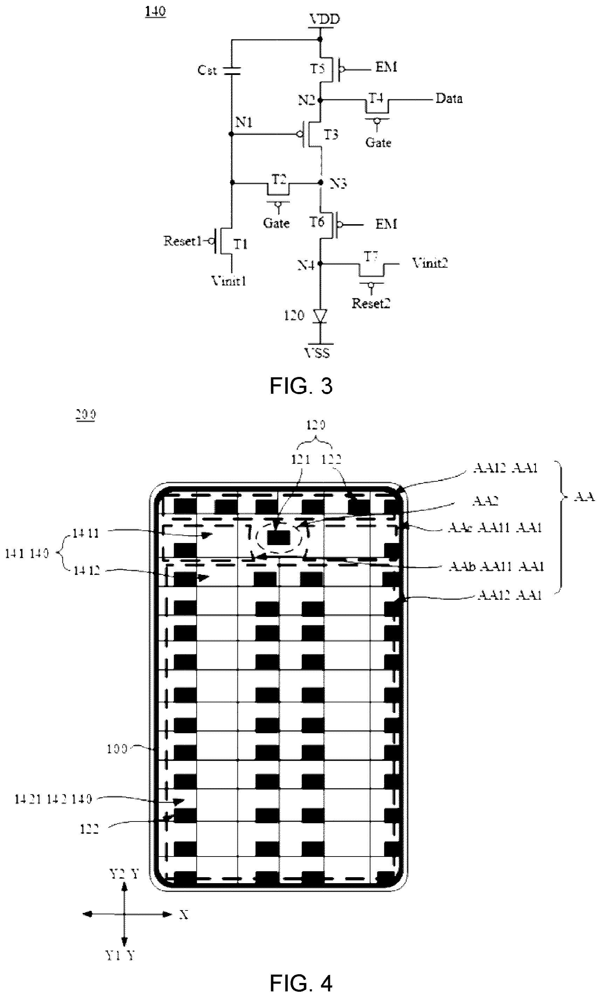

FIG. 3 is a diagram showing a circuit structure of a pixel circuit, in accordance with some embodiments. The embodiments of the present disclosure take the structure of pixel circuit 140 as "7T1C" as an example to exemplarily illustrate the structure and working process of pixel circuit 140. It will be noted that electrical connection relationships between seven transistors and one storage capacitor included in the pixel circuit 140 are not limited to the electrical connection relationship shown in FIG. 3.

It can be understood that during the operation of the pixel circuit 140, signal lines are required to provide corresponding electrical signals. For example, the display panel 100 may further include a first initial signal line Vinit1 for transmitting a first initial signal, a second initial signal line Vinit2 for transmitting a second initial signal, a scanning signal line Gate for transmitting a scanning signal, reset signal lines Reset for transmitting reset signals (including a first reset signal line Reset1 and a second reset signal line Reset2), an enable signal line EM for transmitting an enable signal, a data line Data for transmitting a data signal, a data line Data for transmitting a data signal, and a first voltage signal line VDD for transmitting a voltage signal. The above-mentioned signal lines may be disposed in the plurality of conductive layers 130.

As shown in FIG. 3, the pixel circuit 140 may include a first reset transistor T1, a compensation transistor T2, a driving transistor T3, a switch transistor T4, a first light-emitting control transistor T5, a second light-emitting control transistor T6, a second reset transistor T7 and a storage capacitor Cst.

A gate of the first reset transistor T1 is coupled to the first reset signal line Reset1, a first electrode of the first reset transistor T1 is coupled to the first initial signal line Vinit1 , and a second electrode of the first reset transistor T1 is coupled to a first node N1. A gate of the compensation transistor T2 is coupled to the scanning signal line Gate, a first electrode of the compensation transistor T2 is coupled to the third node N3, and a second electrode of the compensation transistor T2 is coupled to the first node N1. A gate of the driving transistor T3 is coupled to the first node N1, a first electrode of the driving transistor T3 is coupled to a second node N2, and a second electrode of the driving transistor T3 is coupled to a third node N3. A gate of the switch transistor T4 is coupled to the scanning signal line Gate, a first electrode of the switch transistor T4 is coupled to the data line Data, and a second electrode of the switch transistor T4 is coupled to the second node N2.

A gate of the first light-emitting control transistor T5 is coupled to the enable signal line EM, a first electrode of the first light-emitting control transistor T5 is coupled to the first voltage signal line VDD, and a second electrode of the first light-emitting control transistor T5 is coupled to the second node N2. A gate of the second light-emitting control transistor T6 is coupled to the enable signal line EM, a first electrode of the second light-emitting control transistor T6 is coupled to the third node N3, and a second electrode of the second light-emitting control transistor T6 is coupled to the first node N1. A gate of the second reset transistor T7 is coupled to the second reset signal line Reset2, a first electrode of the second reset transistor T7 is coupled to the second initial signal line Vinit2, and a second electrode of the second reset transistor T7 is coupled to the first node N1. That is, as shown in FIG. 3, the second electrode of the second light-emitting control transistor T6 is electrically connected to the second electrode of the second reset transistor T7, and a connection node between the second electrode of the second light-emitting control transistor T6 and the second electrode of the second reset transistor T7 is a fourth node N4. A first electrode of the storage capacitor Cst is coupled to the first node N1, and a second electrode of the storage capacitor Cst is coupled to the first voltage signal line VDD.

It will be noted that in the embodiments of the present disclosure, the transistors in the pixel circuit 140 may all be N-type transistors, or all be P-type transistors, or some are N-type transistors, and the other are P-type transistors. A first electrode of a transistor is one of the source and drain, and a second electrode of a transistor is another of the source and drain. The first node N1, the second node N2, the third node N3, and the fourth node N4 do not represent actual components, but represent junctions of related electrical connections in circuit diagrams. That is, these nodes are nodes that are equivalently formed from the junctions of related electrical connections in circuit diagrams.

For example, the display panel 100 may further include second voltage signal line(s) VSS. As shown in FIG. 3, the fourth node N4 of the pixel circuit 140 may be electrically connected to the anode of the light-emitting device 120, and the second voltage signal line VSS may be electrically connected to the cathode of the light-emitting device 120.

In some examples, the operation process of the pixel circuit 140 includes a reset phase, a data writing and compensation phase, and a light-emitting phase that are performed in sequence.

For example, in the reset phase, the first reset transistor T1 is turned on under the control of the reset signal to transmit the first initial signal to the first node N1, so as to reset the first node N1. Since the first node N1 is electrically connected to the storage capacitor Cst, the gate of the driving transistor T3, and the second electrode of the compensation transistor T2, the storage capacitor Cst, the gate of the driving transistor T3, and the second electrode of the compensation transistor T2 may be reset when the first node N1 is reset. The driving transistor T3 may be turned on under control of the first initial signal.

In the data writing and compensation phase, the second reset transistor T7, the switch transistor T4 and the compensation transistor T2 are turned on under the control of the scanning signal, simultaneously. The second reset transistor T7 transmits the first initial signal to the fourth node N4. Since the fourth node N4 is electrically connected to the anode of the light-emitting device 120, when the fourth node N4 is reset, the anode of the light-emitting device 120 may be reset. The switch transistor T4 transmits the data signal to the second node N2, and the driving transistor T3 is turned on under control of the first node N1 to transmit the data signal at the second node N2 to the third node N3. The compensation transistor T2 transmits the data signal at the third node N3 to the first node N1, so as to charge the driving transistor T3 until the driving transistor T3 is in an off state, so that the compensation of the threshold voltage of the driving transistor T3 is achieved.

In the light-emitting phase, the first light-emitting control transistor T5 and the second light-emitting control transistor T6 are both turned on under the control of the enable signal. The first light-emitting control transistor T5 transmits the voltage signal to the second node N2. The driving transistor T3 transmits the voltage signal from the second node N2 to the third node N3. The second light-emitting control transistor T6 transmits the voltage signal from the third node N3 to the fourth node N4. The light-emitting device 120 emits light due to the voltage signal from the fourth node N4 and the common voltage from the second voltage signal line VSS.

FIG. 4 is a structural diagram of a display apparatus, in accordance with some other embodiments.

In some examples, the plurality of light-emitting devices 120 may include a plurality of first light-emitting devices 121 and a plurality of second light-emitting devices 122, the plurality of first light-emitting devices 121 may be located in the secondary display region AA2, and the plurality of second light-emitting devices 122 may be located in the main display region AA1. It will be noted that, FIG. 4 only shows one second light-emitting device 122 in order to clearly illustrate the structure in the drawing, and the number of the second light-emitting devices 122 is not further limited in the embodiments of the present disclosure.

It can be understood that the plurality of first light-emitting devices 121 may be arranged in an array in the secondary display region AA2, and the plurality of second light-emitting devices 122 may be arranged in an array in the main display region AA1. The structure of the first light-emitting device 121 and the structure of the second light-emitting device 122 may be the same or different. The number of first light-emitting devices 121 and the number of second light-emitting devices 122 may be the same or different. In some examples, the number of first light-emitting devices 121 may be less than the number of second light-emitting devices 122.

It can be understood that the first light-emitting device 121 is disposed in the secondary display region AA2, and the second light-emitting device 122 is disposed in the main display region AA1, so that both the main display region AA1 and the secondary display region AA2 may realize the display function, that is, the display panel 100 may realize full-screen display.

In some examples, the plurality of first light-emitting devices 121 located in the secondary display region AA2 may include first light-emitting devices emitting red light, first light-emitting devices emitting green light, and first light-emitting devices emitting blue light. Along the first direction X, the first light-emitting devices 121 located in the secondary display region AA2 may be arranged in the order of the first light-emitting devices emitting red light, the first light-emitting devices emitting green light, the first light-emitting devices emitting blue light, and the first light-emitting devices emitting green light. In some examples, the plurality of second light-emitting devices 122 located in the main display region AA1 may also be arranged in the order of the second light-emitting devices emitting red light, the second light-emitting devices emitting green light, the second light-emitting devices emitting blue light, and the second light-emitting devices emitting red light.

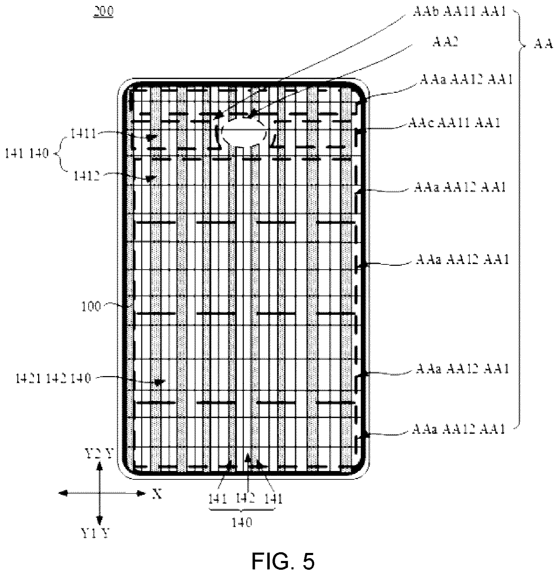

FIG. 5 is a structural diagram of a display apparatus, in accordance with yet some other embodiments.

In some examples, as shown in FIG. 5, the main display region AA1 may include a first main display region AA11 and a second main display region AA12. The first main display region AA11 may be located on both sides of the secondary display region AA2 along the first direction X, and the second main display region AA12 may be located on at least one side of the secondary display region AA2 along the second direction Y.

For example, as shown in FIG. 5, the second direction Y may include a first sub-direction Y1 and a second sub-direction Y2, and the first sub-direction Y1 and the second sub-direction Y2 are opposite to each other. The first sub-direction Y1 may be a direction from the secondary display region AA2 to a lower edge of the display panel 100, and the second sub-direction Y2 may be a direction from the lower edge of the display panel 100 to the secondary display region AA2.

In some examples, the second main display region AA12 may be located on a side of the secondary display region AA2 along the first sub-direction Y1 or the second sub-direction Y2. In some other examples, the second main display region AA12 may further be located on both sides of the secondary display region AA2 along the second direction Y (including the first sub-direction Y1 and the second sub-direction Y2).

Such an arrangement can improve the configuration flexibility of the display panel 100 and satisfy different usage requirements.

The first main display region AA11 and the second main display region AA12 may have the same or different shapes and the same or different areas. For example, as shown in FIG. 1, an area of the first main display region AA11 may be less than an area of the second main display region AA12. The second light-emitting devices 122 may be arranged in an array in the first main display region AA11 and the second main display region AA12.

In some examples, as shown in FIGS. 4 and 5, the plurality of pixel circuits 140 may be located in the main display region AA1. In some examples, the plurality of pixel circuits 140 may be arranged in multiple columns along the first direction X, and the plurality of pixel circuits 140 may be arranged in multiple rows along the second direction Y. In some other examples, the plurality of pixel circuits 140 may be arranged in multiple columns along the first direction X, and the plurality of pixel circuits 140 may be arranged in multiple rows along the second direction Y. In some other examples, the plurality of pixel circuits 140 may further be arranged in other manners. The embodiments of the present disclosure will take an example that the plurality of pixel circuits 140 are arranged in multiple columns along the first direction X, and the plurality of pixel circuits 140 are arranged in multiple rows along the second direction Y to exemplarily illustrate.

It can be understood that it is possible to prevent the pixel circuits 140 from blocking the light from the outside that is irradiated on the display panel 100 by arranging the plurality of pixel circuits 140 in the main display region AA1, so that the external light may pass through the film layers (e.g., the encapsulation layer or the conductive layer, etc.) of the display panel 100 located in the secondary display region AA2, and irradiate on the optical element (e.g., the camera) located in the secondary display region AA2. Therefore, the display panel 100 may achieve the full display with camera.

For example, the circuit structure of the plurality of pixel circuits 140 may be the same or different. In the multiple columns of pixel circuits, the number of pixel circuits 140 included in each column of pixel circuits may be the same or different. In multiple rows of pixel circuit, the number of pixel circuits 140 included in each row of pixel circuits may be the same or different.

For example, as shown in FIGS. 4 and 5, at least one column of pixel circuits 140 among the multiple columns of pixel circuits 140 includes first driving pixel circuits 1411 located in the first main display region AA11. The first driving pixel circuits 1411 may be electrically connected to the first light-emitting devices 121, so that the first driving pixel circuits 1411 may drive the first light-emitting devices 121 to emit light.

It can be understood that the first main display region AA11 is located on both sides of the secondary display region AA2 along the first direction X, and the first driving pixel circuits 1411 are located in the first main display region AA11, so that the first driving pixel circuits 1411 may be located on both sides of the secondary display region AA2 along the first direction X, thereby reducing the distance between the first light-emitting devices 121 and the first driving pixel circuits 1411, and improving the convenience of electrical connection between the first light-emitting devices 121 and the first driving pixel circuits 1411.

In some examples, as shown in FIGS. 4 and 5, the at least one column of pixel circuits 140 further includes redundant pixel circuits 1412 located in the second main display region AA12. Along the second direction Y, the redundant pixel circuits 1412 and the first driving pixel circuits 1411 are arranged in a column. In some examples, as shown in FIG. 5, the column of pixel circuits 140 formed by arranging the redundant pixel circuits 1412 and first driving pixel circuits 1411 may be referred to as a first column of pixel circuits 141.

It can be understood that the number of redundant pixel circuits 1412 and the number of first driving pixel circuits 1411 may be the same or different. In some examples, the number of redundant pixel circuits 1412 is greater than the number of first driving pixel circuits 1411.

In some examples, as shown in FIG. 5, the plurality of pixel circuits 140 further include second driving pixel circuits 1421, and the second driving pixel circuits 1421 are arranged along the second direction Y to form a second column of pixel circuits 142. It can be understood that the second driving pixel circuits 1421 may be located in the first main display region AA11 and the second main display region AA12.

As shown in FIG. 5, the first columns of pixel circuits 141 and the second columns of pixel circuits 142 may be arranged alternately along the first direction X. In some examples, the first columns of pixel circuits 141 and the second columns of pixel circuits 142 may be arranged alternately in sequence along the first direction X. In some other examples, two columns of the second columns of pixel circuits 142 may also be arranged adjacent to each other and located between two columns of the first columns of pixel circuits 141 spaced apart along the first direction X (see FIG. 5). In some other examples, the first columns of pixel circuits 141 and the second columns of pixel circuits 142 may also be arranged alternately along the first direction X in an arrangement manner.

In some examples, the second light-emitting devices 122 are electrically connected to the second driving pixel circuits 1421, so that the second driving pixel circuits 1421 are capable of driving the second light-emitting devices 122 to emit light. The first driving pixel circuits 1411 may drive the first light-emitting devices 121 located in the secondary display region AA2 to emit light, and the second driving pixel circuits 1421 may drive the second light-emitting devices 122 located in the main display region AA1 to emit light. In this way, both the first light-emitting devices 121 and the second light-emitting devices 122 are capable of emitting light, so that the display panel 100 may achieve full-screen display.

In some examples, the first driving pixel circuits 1411 may be electrically connected to the first light-emitting devices 121 in a one-to-one correspondence, so that a first driving pixel circuit 1411 may drive a first light-emitting device 121 to emit light. The second driving pixel circuits 1421 and the second light-emitting devices 122 may be electrically connected in a one-to-one correspondence, so that a second driving pixel circuit 1421 may drive a second light-emitting device 122 to emit light.

In some other examples, a first driving pixel circuit 1411 may be electrically connected to at least two first light-emitting devices 121, so that one first driving pixel circuit 1411 may drive at least two first light-emitting devices 121 to emit light. A second driving pixel circuit 1421 may be electrically connected to at least two second light-emitting devices 122, so that one second driving pixel circuit 1421 may drive at least two second light-emitting devices 122 to emit light.

It can be understood that the redundant pixel circuits 1412 are not electrically connected to the light-emitting devices 120 (including the first light-emitting devices 121 and the second light-emitting devices 122). In some examples, the redundant pixel circuits 1412 may also be referred to as dummy pixel circuits.

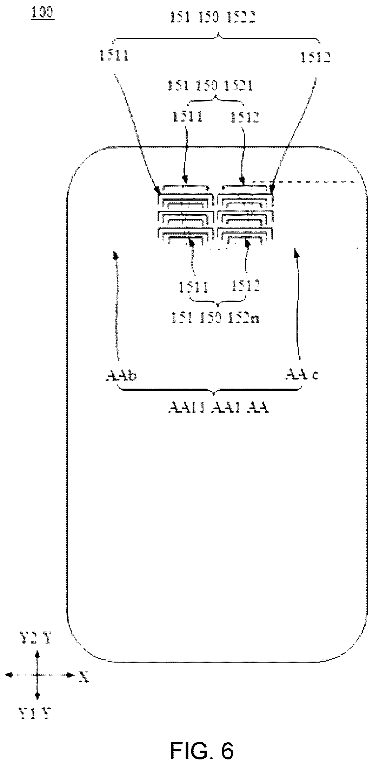

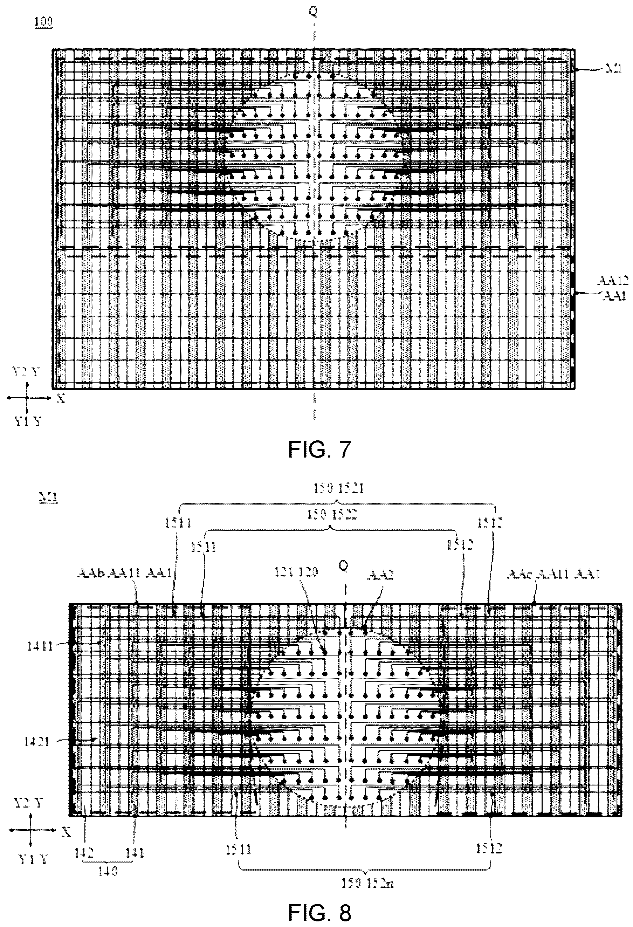

FIG. 6 is a structural diagram of a display panel, in accordance with some other embodiments; FIG. 7 is a partial structural diagram of a display panel, in accordance with some embodiments; and FIG. 8 is an enlarged partial view of the M1 region in FIG. 7.

Hereinafter, referring to FIGS. 6 to 8, the electrical connection between the first light-emitting devices 121 in the secondary display region AA2 and the first driving pixel circuits 1411 in the first main display region AA11 will be described exemplarily.

In some examples, as shown in FIG. 6, the plurality of conductive layers 130 may further include a plurality of connecting line groups 150. As shown in FIGS. 7 and 8, the plurality of connecting line groups 150 may be arranged at intervals along the second direction Y. It can be understood that the intervals between the plurality of connecting line groups 150 may be the same or different.

As shown in FIG. 6, at least one of the plurality of connecting line groups 150 may include at least two connecting lines 151. The at least two connecting lines 151 may be arranged at intervals along the first direction X and extend along the first direction X. As shown in FIGS. 7 and 8, a first end of each of the at least two connecting lines 151 is located in the secondary display region AA2 and electrically connected to the first light-emitting device 121, and a second end of each of the at least two connecting lines 151 extends to the first main display region AA11 and electrically connected to the first driving pixel circuit 1411.

As shown in FIGS. 7 and 8, the plurality of first driving pixel circuits 1411 are located on both sides of the plurality of first light-emitting devices 121 along the first direction X. Therefore, the connecting lines 151 are set to extend along the first direction X, so that the first ends of the connecting lines 151 may be located in the secondary display region AA2 and electrically connected to the first light-emitting devices 121, and the other ends of the connecting lines 151 may extend to the first main display region AA11 and be electrically connected to the first driving pixel circuits 1411.

In some examples, the plurality of connecting line groups 150 may be located in a same conductive layer 130. In some other examples, the plurality of connecting line groups 150 may also be located in different conductive layers 130.

In some examples, the plurality of conductive layers 130 may include a transfer layer 1302 (see FIG. 2), which may be located between the pixel circuit 140 and the light-emitting device 120. A material of the transfer layer 1302 may include a transparent conductive material, such as indium tin oxide (ITO). The plurality of connecting line groups 150 may be located in the transfer layer 1302. In some other examples, the plurality of connecting line groups 150 may also be located in other conductive layers 130 other than the transfer layer 1302.

In some examples, as shown in FIG. 6, the number of connecting line groups 150 may be n, and the n connecting line groups 150 may include a first connecting line group 1521, a second connecting line group 1522, ..., an n-th connecting line group 152n. Here, n is a positive integer.

It can be understood that, as shown in FIG. 6, the first connecting line group 1521 is one of the plurality of connecting line groups 150 that is closest to an upper edge of the display panel 100 along the second direction Y. The second connecting line group 1522 is located on a side of the first connecting line group 1511 away from the upper edge of the display panel 100 along the second direction Y, and so on, the n-th connecting line group 152n is located on a side of an (n-1)-th connecting line group away from the upper edge of the display panel 100 along the second direction Y. It can be understood that the n-th connecting line group 152n is a connecting line group 150 farthest from the upper edge of the display panel 100 along the second direction Y among the plurality of connecting line groups 150. The first connecting line group 1521, the second connecting line group 1522, ..., the n-th connecting line group 152n are arranged along the second direction Y at intervals.

As shown in FIGS. 7 and 8, the plurality of first light-emitting devices 121 may be arranged in an array in the secondary display region AA2. Therefore, the plurality of connecting line groups 150 are arranged at intervals along the second direction Y, so that the plurality of connecting lines 151 may be arranged at intervals along the second direction Y, and the plurality of connecting lines 151 may electrically connect the plurality of first light-emitting devices 121 with the plurality of first driving pixel circuits 1411.

In some examples, a sum of the number of connecting lines 151 in the plurality of connecting line groups 150 may be the same as the number of first light-emitting devices 121.

In some examples, the connecting line 151 may include a connecting line body, a first connecting end, and a second connecting end. The connecting line body may extend along the first direction X, the first connecting end may be connected to an end of the connecting line body, and the first connecting end may extend along the second direction Y to be electrically connected to the first light-emitting device 121 located in the secondary display region AA2. The second connecting end may be connected to an end of the connecting line body away from the first connecting end, and the second connecting end may extend along the second direction Y to be electrically connected to the first driving pixel circuit 1411 located in the first main display region AA11.

In some examples, the first end of the connecting line 151 may be electrically connected to an anode of the first light-emitting device 121, and the second end of the connecting line 151 can be electrically connected to the fourth node N4 of the first driving pixel circuit 1411, so that the first driving pixel circuit 1411 may drive the first light-emitting device 121 to emit light through the connecting line 151.

It can be understood that since the connecting lines 151 extend from the secondary display region AA2 to the first main display region AA11, an orthogonal projection of the connecting lines 151 on the substrate 110 will overlap with an orthogonal projection of the pixel circuits 140 (e.g., the first driving pixel circuits 1411 or the second driving pixel circuits 1421) located in the first main display region AA11 on the substrate 110. That is, the connecting lines 151 may extend through the pixel circuits 140 located in the first main display region AA11.

In this way, it may cause coupling between the connecting lines 151 and the gates of the transistors of the pixel circuits 140 (for example, the gates of the transistors of the pixel circuits 140 are located in the first gate metal layer Gate1 or the second gate metal layer Gate2), so that parasitic capacitors are formed between the connecting lines 151 and the gates of the pixel circuits 140.

**Table 1**

| Item Name | Item 1 | | Item 2 | | Item 3 | |
|---|---|---|---|---|---|---|
| | Second main display region | First main display region | Second main display region | First main display region | Second main display region | First main display region |
| Data | 11.7616 | 12.4768 | 10.1622 | 11.5933 | 9.36425 | 10.6519 |
| EM | 9.4096 | 9.41143 | 9.29853 | 9.30335 | 9.53133 | 9.53308 |
| Gate | 9.33385 | 9.3507 | 11.2885 | 11.3213 | 11.1343 | 11.1557 |
| Cst | 55.5861 | 55.4959 | 78.1754 | 78.2476 | 74.1361 | 74.1714 |
| N1 | 62.7118 | 62.786 | 84.8814 | 84.9563 | 81.0547 | 81.096 |
| N4 | 75.6379 | 86.3931 | 81.9112 | 92.669 | 76.7577 | 87.7303 |
| Reset1 | 8.05783 | 8.09485 | 9.27148 | 9.28735 | 9.96145 | 9.96623 |
| Vinit1 | 12.6826 | 12.885 | 23.8679 | 23.9024 | 22.0186 | 22.0701 |
| Vinit2 | 17.2165 | 17.5391 | 17.8601 | 17.9863 | 21.9644 | 21.7713 |
| Vinit3 | - | - | 11.9468 | 13.6655 | 17.0454 | 17.0986 |
| △Data | 0.7152 | | 1.4311 | | 1.2877 | |
| △EM | 0.0018 | | 0.0048 | | 0.0017 | |
| △Gate | 0.0168 | | 0.0329 | | 0.0214 | |
| Gate_ITO | - | 0.2035 | - | 0.2550 | - | 0.2388 |

In Table 1, Item 1, Item 2, and Item 3 are item names, Data represents the data line, EM represents the enable signal line (e.g., the first enable signal line), Gate represents the scan signal line (e.g., the first scan signal line), Cst represents the storage capacitor, N1 represents the first node, N4 represents the fourth node, Reset1 represents the first reset signal line, Vinit1 represents the first initial signal line, Vinit2 represents the second initial signal line, and Vinit3 represents a third initial signal line. As an example, the third initial signal line may be a portion of the second initial signal line.

The data in Table 1 represent capacitance values. ΔData represents a difference between a capacitance value of a line segment of the data line located in the first main display region AA11 and a capacitance value of a line segment of the data line located in the second main display region AA12; △EM represents a difference between a capacitance value of a line segment of the enable signal line located in the first main display region AA11 and a capacitance value of a line segment of the first enable signal line located in the second main display region AA12; △Gate represents a difference between a capacitance value of a line segment of the scan signal line located in the first main display region AA11 and a capacitance value of a line segment of the scan signal line located in the second main display region AA12. Gate_ITO represents a capacitance value of a parasitic capacitance formed between the connecting line 151 located in the transfer layer 1302 and the gate of the transistor of the pixel circuit 140.

It can be seen from Table 1 that the capacitance value of line segments of the signal lines (e.g., the data line, the first enable signal line, the first scan signal line, the first reset signal line, the first initial signal line, the second initial signal line and the third initial signal line) located in the first main display region AA11 is greater than the capacitance value of the line segments of the signal lines located in the second main display region AA12. Furthermore, the connecting lines 151 located in the transfer layer 1302 and the gates of the transistors of the pixel circuits 140 will be formed with parasitic capacitances therebetween.

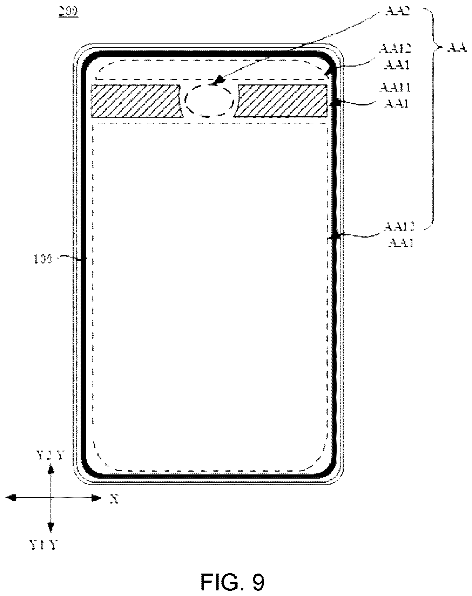

FIG. 9 is a structural diagram of a display apparatus, in accordance with yet some other embodiments.

It can be understood that, as shown in FIG. 9, the parasitic capacitances formed between the connecting lines 151 and the gates of the transistors of the pixel circuits 140 will cause the brightness of the first main display region AA11 to be inconsistent with the brightness of the second main display region AA12, thereby affecting the brightness uniformity of the display panel 100 and causing poor light-emitting of the display panel 100.

In some examples, a phenomenon that the brightness of the first main display region AA11 is inconsistent with the brightness of the second main display region AA12 may be referred to as lateral hole mura (e.g., lateral hole display failure) or horizontal hole mura (e.g., horizontal hole display failure).

**Table 2**

| | Pixel | Ioled/pA | △Ioled% | Gate tr/ns |
|---|---|---|---|---|
| Item 3 | Point2 | 123.997 | 1.98% | 347 |
| | Point4 | 121.593 | | 339 |
| Gate | Point2 | 120.74 | 0.89% | 291 |
| | Point4 | 119.67 | | 284 |
| Vinit | Point2 | 123.659 | 1.94% | 347 |
| Gate & no ITO | Point2 | 122.141 | -0.33% | 281 |
| | Point4 | 122.549 | | 284 |
| Item 1 | - | - | 0.94% | - |

In Table 2, Item 3 is an item name, Point2 represents a current value (unit: picoampere, pA) of the light-emitting device 120 (the second light-emitting device 122) located in the first main display region AA11, and Point 4 represents a current value of the light-emitting device 121 (the second light-emitting device 122) located in the second main display region AA12. △Ioled represents a difference percentage (that is, a ratio of a difference between the current value of the second light-emitting device 122 located in the first main display region AA11 and the current value of the second light-emitting device 122 located in the second main display region AA12 to the current value of the second light-emitting device 122 located in the second main display region AA12) between a current value of the second light-emitting device 122 located in the first main display region AA11 and a current value of the second light-emitting device 122 located in the second main display region AA12. Gate tr represents a time (unit: ns, nanosecond) required for a level signal on the scan signal line to change from a low level to a high level.

It can be understood that the current value of the light-emitting device 120 affects the brightness of the light-emitting device 120. For example, the greater the current value of the light-emitting device 120 is, the greater the brightness of the light-emitting device 120 is; and the less the current value of the light-emitting device 120 is, the less the brightness of the light-emitting device 120 is.

In Item 3, due to the parasitic capacitances between the connecting lines 151 and the gates of the transistors of the pixel circuits 140, the loading of the pixel circuits 140 located in the first main display region AA11 is inconsistent with the loading of the pixel circuits 140 located in the second main display region AA12, so that a time required for the line segments of the scanning signal lines located in the first main display region AA11 to change from a low level to a high level is greater than a time required for the line segments of the scanning signal lines located in the second main display region AA12 to change from a low level to a high level (see Table 2).

It can be seen from Table 2 that in Item 3, a difference percentage between a current value of the second light-emitting device 122 located in the first main display region AA11 and a current value of the second light-emitting device 122 located in the second main display region AA12 is 1.98%. The brightness of the first main display region AA11 and the brightness of the second main display region AA12 are greatly different, so that the display panel 100 has horizontal hole mura.

In Table 2, Gate represents a capacitance of the scan signal line in Item 3 after being adjusted. It can be seen from Table 2 that after the capacitance of the scan signal line is adjusted, a difference percentage between a current value of the second light-emitting device 122 in the first main display region AA11 and a current value of the second light-emitting device 122 in the second main display region AA12 is 0.89%.

In Table 2, Vinit represents a capacitance of the initial signal line in Item 3 after being adjusted. It can be seen from Table 2 that after the capacitance of the initial signal line is adjusted, a difference percentage between a current value of the second light-emitting device 122 in the first main display region AA11 and a current value of the second light-emitting device 122 in the second main display region AA12 is 1.94%.

In Table 2, Item 1 is an item name. It can be seen from Table 2 that in Item 1, a difference percentage between a current value of the second light-emitting device 122 located in the first main display region AA11 and a current value of the second light-emitting device 122 located in the second main display region AA12 is 0.94%.

In Table 2, Gate & no ITO represents a capacitance of the scan signal line in Item 3 after being adjusted, with eliminating a parasitic capacitance generated between the connecting line 151 and the gates of the transistors of the pixel circuits 140 (e.g., implemented by simulation). It can be seen from Table 2 that the percentage difference between the current value of the second light-emitting device 122 located in the first main display region AA11 and the current value of the second light-emitting device 122 located in the second main display region AA12 may be reduced from 1.98% in Item 3 to -0.33% by adopting this method, thereby reducing the brightness difference between the first main display region AA11 and the second main display region AA12 and improving the brightness uniformity of the display panel 100.

That is, the parasitic capacitances formed between the connecting lines 151 and the gates of the transistors of the pixel circuits 140 located in the first main display region AA11 will affect the loading of the pixel circuits 140 (e.g., the first driving pixel circuits 1411 or the second driving pixel circuits 1421) located in the first main display region AA11, which may result in a great difference in brightness between the first main display region AA11 and the second main display region AA12, so that the display panel 100 has horizontal hole mura.

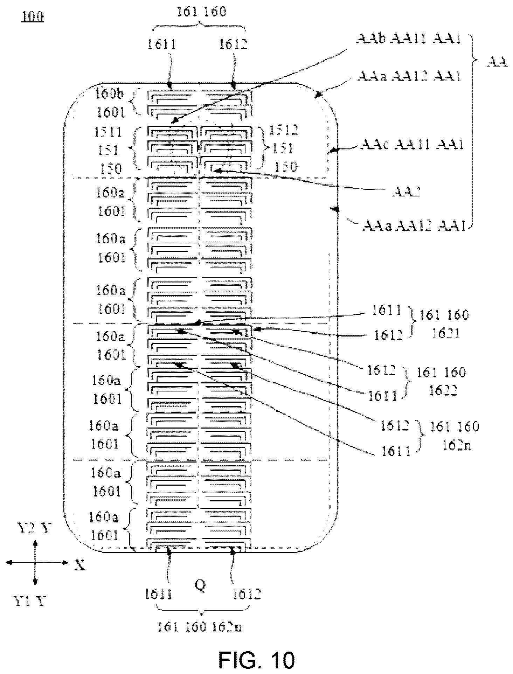

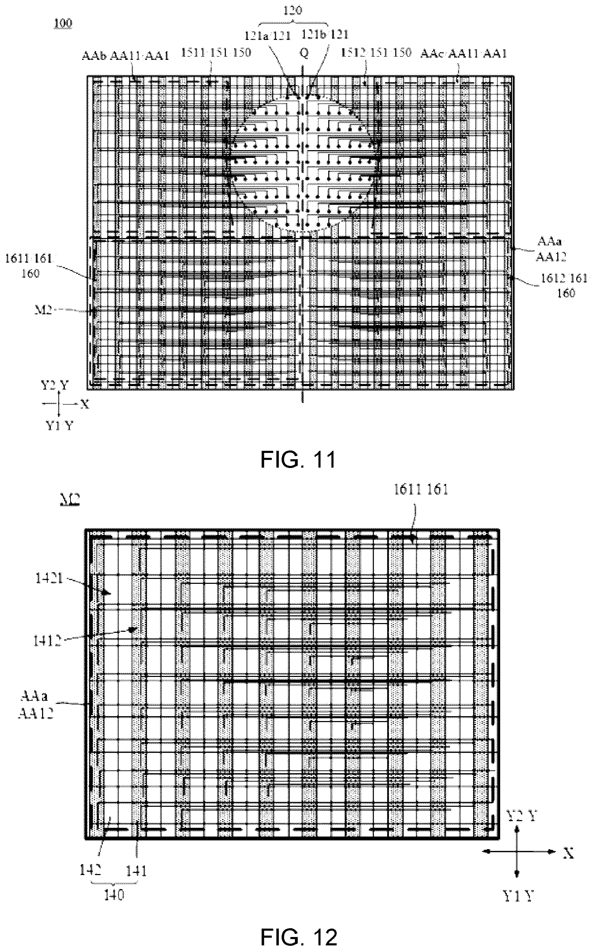

FIG. 10 is a structural diagram of yet another display panel, in accordance with some embodiments; FIG. 11 is a partial structural diagram of a display panel, in accordance with some other embodiments; and FIG. 12 is an enlarged partial view of the M2 region in FIG. 11.

Based on this, as shown in FIGS. 10 to 12, in the embodiments of the present disclosures, the plurality of conductive layers 130 may further include plurality of compensation line groups 160. The plurality of compensation line groups 160 are disposed at intervals along the second direction Y. At least one of the plurality of compensation line groups 160 includes at least one compensation line 161. The at least one compensation line 161 extends along the first direction X, and the at least one compensation line 161 is configured to be electrically connected to the constant voltage signal.

It can be understood that the number of compensation line groups 160 and the number of connecting line groups 150 may be the same or different. In some examples, as shown in FIG. 10, the number of compensation line groups 160 may be greater than the number of connecting line groups 150. The plurality of compensation line groups 160 may be arranged at intervals along the second direction Y and evenly distributed in the second main display region AA12.

In some examples, the compensation line group 160 may be adjacent to the secondary display region AA2 along the second direction Y. In some other examples, the compensation line group 160 may also be disposed spaced apart from the secondary display region AA2 along the second direction Y.

It can be understood that the compensation line group 160 may include only one compensation line 161, or the compensation line group 160 may include two, three or more compensation lines 161. The numbers of compensation lines 161 included in different compensation line groups 160 may be the same or different. In some examples, the number of compensation lines 161 included in one compensation line group 160 may be the same as the number of connecting lines 151 included in one connecting line group 150. In some other examples, the number of compensation lines 161 included in a compensation line group 160 may also be less than the number of connecting lines 151 included in a connecting line group 150.

In some examples, as shown in FIGS. 10 and 11, the plurality of compensation line groups 160 may form compensation unit(s) 1601. The compensation unit(s) 1601 may include first compensation unit(s) 160a. As shown in FIG. 10, the first compensation unit 160a may include a first compensation line group 1621, a second compensation line group 1622, ..., and an n-th compensation line group 162n.

It can be understood that, as shown in FIG. 10, in the multiple compensation line groups 160 of the first compensation unit 160a, the first compensation line group 1621 is a compensation line group 160 that is closest to an upper edge of the display panel 100 along the second direction Y, the second compensation line group 1622 is located on a side of the first compensation line group 1611 away from the upper edge of the display panel 100 along the second direction Y, and so on; and the n-th compensation line group 162n is located on a side of the (n-1)-th compensation line group away from the upper edge of the display panel 100 along the second direction Y. It can be understood that, in the multiple compensation line groups 160 of the first compensation unit 160a, the n-th compensation line group 162n is a compensation line group 160 farthest from the upper edge of the display panel 100 along the second direction Y. The first compensation line group 1621, the second compensation line group 1622, ..., the n-th compensation line group 162n are arranged along the second direction Y at intervals.

It can be understood that the number of the compensation line groups 160 in the first compensation unit 160a is the same as the number of the connecting line groups 150 (e.g., both are n). Since the number of compensation line groups 160 may be greater than the number of connecting line groups 150, the plurality of compensation line groups 160 may form multiple compensation units 1601.

In some examples, the multiple compensation units 1601 may include a plurality of first compensation units 160a, and the numbers of compensation line groups 160 included in the plurality of first compensation units 160a are the same (e.g., each is n). The plurality of first compensation units 160a may be arranged adjacent to each other along the second direction Y.

It can be understood that the plurality of compensation line groups 160 may be arranged at intervals along the second direction Y, and the compensation line 161 may extend along the first direction X, so that the arrangement of the plurality of compensation line groups 160 may be the same as the arrangement of the plurality of connecting line groups 150, and the extending direction of the compensation line 161 may be the same as the extending direction of the connecting line 151.

Since the compensation line groups 160 are located in the second main display region AA12, an orthogonal projection of the compensation lines 161 on the substrate 110 may overlap with an orthogonal projection of the pixel circuits 140 (e.g., the redundant pixel circuits 1412 or the second driving pixel circuits 1421) located in the second main display region AA12 on the substrate 110. In addition, the compensation lines 161 are electrically connected to the constant voltage signal, so that the compensation lines 161 may be coupled to the pixel circuits 140 located in the second main display region AA12 (that is, parasitic capacitances are generated between the compensation lines 161 and the gates of the transistors of the pixel circuits 140 located in the second main display region AA12), so that Tr (the time required for the level signal on the scanning signal lines to change from a low level to a high level) and Tf (the time required for the level signal on the scanning signal lines to change from a high level to a low level) of the scanning signal lines of the pixel circuits 140 located in the second main display region AA12 may be increased, thereby compensating for the influence of the connecting lines 151 on the loading of the pixel circuits 140 located in the first main display region AA11. In this way, the difference between the loading of the pixel circuits 140 located in the first main display region AA11 and the loading of the pixel circuits 140 located in the second main display region AA12 may be reduced, and the brightness uniformity of the display panel 100 may be improved.

In some examples, as shown in FIGS. 10 and 11, the number of pixel circuits 140 through which the connecting lines 151 in an a-th connecting line group 150 pass along the first direction X is less than or equal to the number of pixel circuits 140 through which the compensation lines 161 in an a-th compensation line group 160 pass along the first direction X, where a is any positive integer between 1 and n.

It can be understood that the number of pixel circuits 140 through which the connecting lines 151 in the connecting line group 150 pass along the first direction X is a sum of the numbers of pixel circuits 140 through which all of the connecting lines 151 in the connecting line group 150 pass along the first direction X. The numbers of pixel circuits 140 through which connecting lines 151 in different connecting line groups 150 pass along the first direction X may be the same or different.

The number of pixel circuits 140 through which the compensation lines 161 in the compensation line group 160 pass along the first direction X is a sum of numbers of pixel circuits 140 through which all of the compensation lines 161 in the compensation line group 160 pass along the first direction X. The numbers of pixel circuits 140 through which compensation lines 161 in different compensation line groups 160 pass along the first direction X may be the same or different.

It can be understood that the number of pixel circuits 140 through which the connecting lines 151 in the a-th connecting line group 150 pass along the first direction X is less than or equal to the number of pixel circuits 140 through which the compensation lines 161 in the a-th compensation line group 160 pass along the first direction X, where a is any positive integer between 1 and n. That is, the number of pixel circuits 140 through which the connecting lines 151 in the first connecting line group 1521 pass along the first direction X is less than or equal to the number of pixel circuits 140 through which the compensation lines 161 in the first compensation line group 1621 pass along the first direction X, the number of pixel circuits 140 through which the connecting lines 151 in the second connecting line group 1522 pass along the first direction X is less than or equal to the number of pixel circuits 140 through which the compensation lines 161 in the second compensation line group 1622 pass along the first direction X, and so on; and the number of pixel circuits 140 through which the connecting lines 151 in the n-th connecting line group 152n pass along the first direction X is less than or equal to the number of pixel circuits 140 through which the compensation lines 161 in the n-th compensation line group 162n pass along the first direction X.

With such arrangement, the number of pixel circuits 140 through which the connecting lines 151 in each of the connecting line groups 150 pass along the first direction X may be one-to-one less than or equal to the number of pixel circuits 140 through which the compensation lines 161 in a respective one of the compensation line groups 160 in the first compensation unit 160a pass along the first direction X, so that the coupling generated between the first compensation unit 160a and the pixel circuits 140 in the second main display region AA12 may be the same or substantially the same as the coupling generated between the connecting line groups 150 and the pixel circuits 140 located in the first main display region AA11. Therefore, the first compensation units 160a may reduce the difference between the loading of the pixel circuits 140 located in the second main display region AA12 and the loading of the pixel circuits 140 located in the first main display region AA11, improve the horizontal hole mura of the display panel 100, and improve the brightness uniformity of different positions of the display panel 100, thereby improving the display performance of the display panel 100.

In some examples, in a first compensation unit 160a, a length of the connecting lines 151 in the a-th connecting line group 150 along the first direction X is less than or equal to a length of the compensation lines 161 in the a-th compensation line group 160 along the first direction X, so that the number of pixel circuits 140 through which the connecting lines 151 in the a-th connecting line group 150 pass along the first direction X may be less than or equal to the number of pixel circuits 140 through which the compensation lines 161 in the a-th compensation line group 160 pass along the first direction X.

It can be understood that, since the secondary display region AA2 is not provided with the pixel circuits 140 therein, the line segments of the connecting lines 151 located in the secondary display region AA2 will not overlap with the pixel circuits 140. Therefore, in some examples, in a first compensation unit 160a, a length of the line segments of the connecting lines 151 in the a-th connecting line group 150 located in the first main display region AA11 along the first direction X may be set to be less than or equal to a length of the compensation lines 161 in the a-th compensation line group 160 along the first direction X, so that the number of pixel circuits 140 through which the connecting lines 151 in the a-th connecting line group 150 pass along the first direction X may be less than or equal to the number of pixel circuits 140 through which the compensation lines 161 in the a-th compensation line group 160 pass along the first direction X. In the embodiments of the present disclosure, by providing the plurality of connecting line groups 150, the plurality of first light-emitting devices 121 located in the secondary display region AA2 may be electrically connected to the plurality of first driving pixel circuits 1411 located in the first main display region AA11, so that the first driving pixel circuits 1411 may drive the first light-emitting devices 121 to emit light.

In addition, the plurality of conductive layers 130 includes the plurality of compensation line groups 160, and the plurality of compensation line groups 160 are arranged at intervals along the second direction Y, and the compensation line 161 in the compensation line group 160 extends along the first direction X, so that the arrangement of the compensation line group 160 can be the same as the arrangement of the connecting line group 150, and the extending direction of the compensation line 161 can be the same as the extending direction of the connecting line 151.

The compensation lines 161 are electrically connected to the constant voltage signal, so that the compensation lines 161 can be coupled to the pixel circuits 140 (e.g., the redundant pixel circuits 1412 or the second driving pixel circuits 1421) located in the second main display region AA12. The number of compensation line groups 160 in the first compensation unit 160a is the same as the number of connecting line groups 150 (both are n), and the number of pixel circuits 140 through which the connecting lines 151 in the a-th connecting line group 150 pass along the first direction X may be less than or equal to the number of pixel circuits 140 through which the compensation lines 161 in the a-th compensation line group 160 pass along the first direction X, so that the coupling generated between the first compensation unit 160a and the pixel circuits 140 in the second main display region AA12 may be the same or substantially the same as the coupling generated between the connecting line groups 150 and the pixel circuits 140 located in the first main display region AA11. In this way, the first compensation unit 160a is capable of reducing the difference between the loading of the pixel circuits 140 located in the second main display region AA12 and the loading of the pixel circuits 140 located in the first main display region AA11, so as to improve the horizontal hole mura of the display panel 100, and improve the brightness uniformity of different positions of the display panel 100, thereby improving the display performance of the display panel 100.

It can be seen from the above that the compensation lines 161 are electrically connected to the constant voltage signal. In some examples, at least one end of the at least one compensation line 161 is electrically connected to the redundant pixel circuit 1412.

It can be understood that the redundant pixel circuit 1412 is capable of providing the constant voltage signal for the compensation line 161. Since the redundant pixel circuit 1412 is not electrically connected to the light-emitting device 120 (including the first light-emitting device 121 and the second light-emitting device 122), the light-emitting device 120 will not be affected when the compensation line 161 is electrically connected to the redundant pixel circuit 1412.

By setting the at least one end of the at least one compensation line 161 being electrically connected to the redundant pixel circuit 1412, so that the redundant pixel circuit 1412 is capable of providing the constant voltage signal for the compensation line 161, and the compensation lines 161 may compensate for the loading of the pixel circuits 140 located in the second main display region AA12, thereby improving the brightness uniformity of the display panel 100.

In some examples, an end of the compensation line 161 is electrically connected to the redundant pixel circuit 1412. In some other examples, both ends of the compensation line 161 are electrically connected to the redundant pixel circuit 1412.

In some examples, the at least one end of the at least one compensation line 161 is electrically connected to a fourth node N4 of the redundant pixel circuit 1412.

It can be understood that the second end of the connecting line 151 is electrically connected to the fourth node N4 of the first driving pixel circuit 1411, therefore, the at least one end of the at least one compensation line 161 is set to be electrically connected to the fourth node N4 of the redundant pixel circuit 1412, so that the compensation line 161 may compensate for the loading of the pixel circuits 140 located in the second main display region AA12, thereby improving the brightness uniformity of the display panel 100.

In some examples, the at least one end of the at least one compensation line 161 is electrically connected to the second voltage signal line(s) VSS.

Since the second voltage signal line VSS is electrically connected to the cathode of the light-emitting devices 120 and is used to provide a voltage signal for the light-emitting devices 120, the second voltage signal line VSS is capable of providing the constant voltage signal for the compensation lines 161, so that the compensation lines 161 may compensate for the loading of the pixel circuits 140 located in the second main display region AA12, thereby improving the brightness uniformity of the display panel 100.

It can be understood that in a case where the compensation lines 161 is electrically connected to the second voltage signal line VSS, the second voltage signal line VSS may provide a cathode voltage for the compensation lines 161 without affecting the light-emitting devices 120. That is, the compensation lines 161 are electrically connected to the redundant pixel circuits 1412 or the second voltage signal line VSS, and will not affect the light-emitting devices 120, thereby improving the light-emitting reliability of the display panel 100.

In some examples, in a case where the compensation line group 160 includes a plurality of compensation lines 161, the plurality of compensation lines 161 may all be electrically connected to the redundant pixel circuits 1412. In some other examples, the plurality of compensation lines 161 may all be electrically connected to the second voltage signal line VSS. In some other examples, a part of the compensation lines 161 may be electrically connected to the redundant pixel circuits 1412, and another part of the compensation lines 161 may be electrically connected to the second voltage signal line VSS.

In some examples, as shown in FIG. 10, the second main display region AA12 may include a plurality of first sub-regions AAa. The plurality of first sub-regions AAa are arranged adjacent to each other along the second direction Y, and a first sub-region AAa is arranged adjacent to the first main display region AA11 along the second direction Y At least one first compensation unit 160a is located in a same first sub-region AAa.

It can be understood that the plurality of first sub-regions AAa may have the same or different shapes and the same or different areas.

In some examples, one first compensation unit 160a is located in a first sub-region AAa. In some other examples, two, three or more first compensation units 160a are located in the same first sub-region AAa.

In some examples, the line segments of the compensation line 161 in the first compensation unit 160a are all located in the first sub-region AAa. In some other examples, a part of the line segments of each compensation line 161 in the first compensation unit 160a is located in the first sub-region AAa.

As shown in FIG. 10, at least one first compensation unit 160a is arranged to be located in the same first sub-region AAa, so that the first compensation unit 160a may compensate for the loading of the pixel circuits 140 located at different positions in the second main display region AA12, which may reduce a difference between the loading of the pixel circuits 140 located at different positions in the second main display region AA12 and the loading of the pixel circuits 140 located in the first main display region AA11, thereby improving the brightness uniformity of the display panel 100.

In some examples, the plurality of connecting line groups 150 and the plurality of compensation line groups 160 are located in the same conductive layer 130.

Disposing the plurality of connecting line groups 150 and the plurality of compensation line groups 160 in the same conductive layer may improve a consistency of the loading of the pixel circuits 140 located in the second main display region AA12 and the loading of the pixel circuits 140 located in the first main display region AA11, thereby improving the brightness uniformity of the display panel 100, and improving the display performance of the display panel 100.

In addition, disposing the plurality of connecting line groups 150 and the plurality of compensation line groups 160 in the same conductive layer may further improve the etching uniformity of the conductive layer 130, so that the pattern in the conductive layer 130 may be more uniform, and a consistency of parasitic capacitances formed between the conductive layer 130 and other conductive layers 130 at different positions may be improved, thereby improving the display effect of the display panel 100. Moreover, disposing the plurality of connecting line groups 150 and the plurality of compensation line groups 160 in the same conductive layer may further improve the processing convenience of the display panel 100.

For example, the plurality of connecting line groups 150 and the plurality of compensation line groups 160 may be located in the transfer layer 1302, so that the plurality of compensation lines 161 and the plurality of connecting lines 151 may be located in the same conductive layer 130.

In some examples, as shown in FIG. 10, the first main display region AA11 may include a second sub-region AAb and a third sub-region AAc, the second sub-region AAb may be located on a side of the secondary display region AA2 along the first direction X, and the third sub-region AAc may be located on a side of the secondary display region AA2 away from the second sub-region AAb along the first direction X.

It can be understood that the second sub-region AAb and the third sub-region AAc may have the same or different shapes and the same or different areas.

For example, as shown in FIG. 10, the at least one connecting line group 150 may include first connecting line(s) 1511 and second connecting line(s) 1512. It can be understood that the first connecting line 1511 and the second connecting line 1512 may be arranged along the first direction X at intervals. A second end of the first connecting line 1511 may be located in the second sub-region AAb, and a second end of the second connecting line 1512 may be located in the third sub-region AAc.

It can be understood that a first end of the first connecting line 1511 may be located in the secondary display region AA2 and electrically connected to a first light-emitting device 121, and the second end of the first connecting line 1511 may extend into the second sub-region AAb and be electrically connected to a first driving pixel circuit 1411 located in the second sub-region AAb. A first end of the second connecting line 1512 may be located in the secondary display region AA2 and electrically connected to a first light-emitting device 121, and the second end of the second connecting line 1512 may extend into the third sub-region AAc and be electrically connected to a first driving pixel circuit 1411 located in the third sub-region AAc.

The plurality of connecting lines 151 are set to include first connecting lines 1511 and second connecting lines 1512, the second ends of the first connecting lines 1511 are located in the second sub-region AAb, and the second ends of the second connecting lines 1512 are located in the third sub-region AAc, so that the second ends of the plurality of connecting lines 151 may be distributed on both sides of the secondary display region AA2 along the first direction X, which may improve the distribution uniformity of the plurality of connecting lines 151 in the transfer layer 1302, improve the etching uniformity of the transfer layer 1302, and improve a consistency of parasitic capacitances formed between the transfer layer 1302 and other conductive layers 130 at different positions, thereby improving the display effect of the display panel 100.

Furthermore, the second ends of the plurality of connecting lines 151 are set to be distributed along the first direction X on both sides of the secondary display region AA2, which may improve the convenience of arranging the plurality of connecting lines 151, reduce the risk of short circuit between different connecting lines 151, and improve the processing convenience of the display panel 100.

In some examples, as shown in FIG. 10, the secondary display region AA2 includes a center line Q along the second direction Y extending through a center of the secondary display region AA2. It can be understood that the center line Q of the secondary display region AA2 is a virtual straight line. In a case where the secondary display region AA2 is located in the middle of the display panel 100 along the first direction X, the center line Q of the secondary display region AA2 may also be a center line of the display panel 100.

For example, as shown in FIG. 11, the plurality of first light-emitting devices 121 includes a plurality of first first light-emitting devices and a plurality of second first light-emitting devices. The plurality of first first light-emitting devices and the plurality of second first light-emitting devices are located on both sides of the center line Q of the secondary display region AA2 along the first direction X. The plurality of first connecting lines 1511 are electrically connected to the plurality of first first light-emitting devices. For example, the plurality of first connecting lines 1511 are electrically connected to the plurality of first first light-emitting devices in a one-to-one correspondence. The plurality of second connecting lines 1512 are electrically connected to the plurality of second first light-emitting devices. For example, the plurality of second connecting lines 1512 are electrically connected to the plurality of second first light-emitting devices in a one-to-one correspondence.

The plurality of first first light-emitting devices and the plurality of second first light-emitting devices are located on both sides of the center line Q of the secondary display region AA2 along the first direction X, which may improve the distribution uniformity of the plurality of first light-emitting devices 121 in the secondary display region AA2, thereby improving the brightness uniformity of the secondary display region AA2. For example, the number of the plurality of first first light-emitting devices and the number of the plurality of second first light-emitting devices may be the same or different.

In some examples, the number of first connecting lines 1511 is the same as the number of first first light-emitting devices, so that the plurality of first connecting lines 1511 may be electrically connected to the plurality of first first light-emitting devices in a one-to-one correspondence. The number of the second connecting lines 1512 is the same as the number of the second first light-emitting devices, so that the plurality of second connecting lines 1512 may be electrically connected to the plurality of second first light-emitting devices in a one-to-one correspondence.

For example, as shown in FIG. 11, the plurality of first connecting lines 1511 and the plurality of second connecting lines 1512 are respectively located on both sides of the center line Q of the secondary display region AA2 along the first direction X.

It can be understood that the second sub-region AAb and the third sub-region AAc are located on both sides of the secondary display region AA2 along the first direction X. The plurality of first connecting lines 1511 may electrically connect the plurality of first first light-emitting devices with the plurality of first driving pixel circuits 1411 located in the second sub-region AAb in a one-to-one correspondence; and the plurality of second connecting lines 1512 may electrically connect the plurality of second first light-emitting devices with the plurality of first driving pixel circuits 1411 located in the third sub-region AAc in a one-to-one correspondence.

In this way, the first driving pixel circuits 1411 located on both sides of the center line Q of the secondary display region AA2 along the first direction X may be electrically connected to the first light-emitting devices 121 (including the first first light-emitting devices and the second first light-emitting devices) located on both sides of the center line Q of the secondary display region AA2 along the first direction X respectively, thereby reducing a distance between a first light-emitting device 121 and a first driving pixel circuit 1411 electrically connected to the first light-emitting device 121, improving the convenience of electrical connection between the first light-emitting device 121 and the first driving pixel circuit 1411, and thus improving the processing convenience of the display panel 100.

In some examples, the first connecting line(s) 1511 include a first first connecting line and a second first connecting line. A distance between a first end of the first first connecting line and an edge of the secondary display region AA2 is greater than a distance between a first end of the second first connecting line and the edge of the secondary display region AA2; and a distance between a second end of the first first connecting line and the edge of the secondary display region AA2 is greater than a distance between a second end of the second first connecting line and the edge of the secondary display region AA2.

Such an arrangement enables the first connecting lines 1511 to electrically connect the first first first light-emitting devices with the first driving pixel circuits 1411 located in the second sub-region AAb in a "close to close, far to far" manner. That is, a first first light-emitting device proximate to the edge of the secondary display region AA2 may be electrically connected to a first driving pixel circuit 1411 proximate to the edge of the secondary display region AA2. A first first light-emitting device away from the edge of the secondary display region AA2 may be electrically connected to a first driving pixel circuit 1411 away from the edge of the secondary display region AA2.

In this way, the convenience of arranging the first connecting lines 1511 may be improved, and the risk of short circuit between the plurality of first connecting lines 1511 may be reduced.

In some other examples, the first connecting lines 1511 may also electrically connect the first first light-emitting devices with the first driving pixel circuits 1411 located in the second sub-region AAb in a "close to far" manner.

That is, a first first light-emitting device proximate to the edge of the secondary display region AA2 may be electrically connected to a first driving pixel circuit 1411 away from the edge of the secondary display region AA2. A first first light-emitting device away from the edge of the secondary display region AA2 may be electrically connected to a first driving pixel circuit 1411 proximate to the edge of the secondary display region AA2.

In some examples, the second connecting lines 1512 includes first second connecting lines and second second connecting lines. A distance between a first end of the first second connecting line and the edge of the secondary display region AA2 is greater than a distance between a first end of the second second connecting line and the edge of the secondary display region AA2. And, a distance between a second end of the first second connecting line and the edge of the secondary display region AA2 is greater than a distance between a second end of the second second connecting line and the edge of the secondary display region AA2.

Such an arrangement enables the second connecting lines 1512 to electrically connect the first second first light-emitting devices with the first driving pixel circuits 1411 located in the third sub-region AAc in a "close to close, far to far" manner. That is, a second first light-emitting device proximate to the edge of the secondary display region AA2 may be electrically connected to a first driving pixel circuit 1411 proximate to the edge of the secondary display region AA2. A second first light-emitting device away from the edge of the secondary display region AA2 may be electrically connected to a first driving pixel circuit 1411 away from the edge of the secondary display region AA2.

In this way, the convenience of arranging the second connecting lines 1512 may be improved, and the risk of short circuit between the plurality of second connecting lines 1512 may be reduced.

In some other examples, the second connecting lines 1512 may also electrically connect the second first light-emitting devices to the first driving pixel circuits 1411 located in the third sub-region AAc in a "close to far" manner.

That is, a second first light-emitting device proximate to the edge of the secondary display region AA2 may be electrically connected to a first driving pixel circuit 1411 away from the edge of the secondary display region AA2. A second first light-emitting device away from the edge of the secondary display region AA2 may be electrically connected to a first driving pixel circuit 1411 proximate to the edge of the secondary display region AA2.

In some examples, as shown in FIGS. 10 and 11, the at least one compensation line group 160 includes first compensation line(s) 1611 and second compensation line(s) 1612. The first compensation line(s) 1611 and the second compensation line(s) 1612 are arranged at intervals along the first direction X.

The number of pixel circuits 140 through which the first connecting line(s) 1511 in the a-th connecting line group 150 pass along the first direction X is the same as the number of pixel circuits 140 through which the first compensation line(s) 1611 in the a-th compensation line group 160 pass along the first direction X; and the number of pixel circuits 140 through which the second connecting line(s) 1512 in the a-th connecting line group 150 pass along the first direction X is the same as the number of pixel circuits 140 through which the second compensation line(s) 1612 in the a-th compensation line group 160 pass along the first direction X.

It can be understood that a is any positive integer between 1 and n. That is, the number of pixel circuits 140 through which the first connecting line(s) 1511 in the first connecting line group 1521 pass along the first direction X is the same as the number of pixel circuits 140 through which the first compensation line(s) 1611 in the first compensation line group 1621 pass along the first direction X, and the number of pixel circuits 140 through which the second connecting line(s) 1512 in the first connecting line group 1521 pass along the first direction X is the same as the number of pixel circuits 140 through which the second compensation line(s) 1612 in the first compensation line group 1621 pass along the first direction X. The number of pixel circuits 140 through which the first connecting line(s) 1511 in the second connecting line group 1522 pass along the first direction X is the same as the number of pixel circuits 140 through which the first compensation line(s) 1611 in the second compensation line group 1622 pass along the first direction X, and the number of pixel circuits 140 through which the second connecting line(s) 1512 in the second connecting line group 1522 pass along the first direction X is the same as the number of pixel circuits 140 through which the second compensation line(s) 1612 in the second compensation line group 1622 pass along the first direction X. And so on, the number of pixel circuits 140 through which the first connecting line(s) 1511 in the n-th connecting line group 152n pass along the first direction X is the same as the number of pixel circuits 140 through which the first compensation line(s) 1611 in the n-th compensation line group 162n pass along the first direction X, and the number of pixel circuits 140 through which the second connecting line(s) 1512 in the n-th connecting line group 152n pass along the first direction X is the same as the number of pixel circuits 140 through which the second compensation line(s) 1612 in the n-th compensation line group 162n pass along the first direction X.

In this way, the number of pixel circuits 140 through which the first connecting line(s) 1511 in each of the connecting line groups 150 pass along the first direction X can be one-to-one less than or equal to the number of pixel circuits 140 through which the first compensation line(s) 1611 in a respective one of the compensation line groups 160 in the first compensation unit 160a pass along the first direction X; and the number of pixel circuits 140 through which the second connecting line(s) 1512 in each of the connecting line groups 150 pass along the first direction X can be one-to-one less than or equal to the number of pixel circuits 140 through which the second compensation line(s) 1612 in the respective one of the compensation line groups 160 in the first compensation unit 160a pass along the first direction X.

In this way, the first compensation lines 1611 may compensate for the influence of the first connecting lines 1511 on the loading of the pixel circuits 140 located in the first main display region AA11, and the second compensation lines 1612 may compensate for the influence of the second connecting lines 1512 on the loading of the pixel circuits 140 located in the first main display region AA11, so that the compensation lines 161 (including the first compensation lines 1611 and the second compensation lines 1612) may reduce the difference between the loading of the pixel circuits 140 located in the first sub-region AAa and the loading of the pixel circuits 140 located in the first main display region AA11, thereby improving the brightness uniformity of different positions of the display panel 100, improving the horizontal hole mura of the display panel 100, and improving the display performance of the display panel 100.

Moreover, the above-mentioned arrangement may further improve the regularity of the arrangement of the first compensation lines 1611 and the second compensation lines 1612, improve the etching uniformity of the transfer layer 1302, and improve the consistency of the parasitic capacitances formed between the transfer layer 1302 and other conductive layers 130 at different positions, thereby improving the display effect of the display panel 100.

For example, as shown in FIGS. 10 to 12, the number of first connecting lines 1511 is the same as the number of first compensation lines 1611 in the first compensation unit 160a. The number of second connecting lines 1512 is the same as the number of second compensation lines 1612 in the first compensation unit 160a.

In some examples, a length of the first connecting line 1511 in the a-th connecting line group 150 along the first direction X is the same as a length of the first compensation line 1611 in the a-th compensation line group 160 along the first direction X, so that the number of pixel circuits 140 through which the first connecting line 1511 in the a-th connecting line group 150 passes along the first direction X is the same as the number of pixel circuits 140 through which the first compensation line 1611 in the a-th compensation line group 160 passes along the first direction X.

A length of the second connecting line 1512 in the a-th connecting line group 150 along the first direction X is the same as a length of the second compensation line 1612 in the a-th compensation line group 160 along the first direction X, so that the number of pixel circuits 140 through which the second connecting line 1512 in the a-th connecting line group 150 passes along the first direction X is the same as the number of pixel circuits 140 through which the second compensation line 1612 in the a-th compensation line group 160 passes along the first direction X.

In some examples, an arrangement position of the first connecting line 1511 in the a-th connecting line group along the first direction X is at least partially aligned with an arrangement position of the first compensation line 1611 in the a-th compensation line group along the first direction X.

In some examples, the arrangement position of the first connecting line 1511 in the a-th connecting line group along the first direction X may be completely aligned with the arrangement position of the first compensation line 1611 in the a-th compensation line group along the first direction X (see FIGS. 10 to 12). In this case, an arrangement position of the first end of the first connecting line 1511 in the a-th connecting line groups is aligned with an arrangement position of the first end of the first compensation line 1611 in the a-th compensation line group (the ends of the first compensation line 1611 proximate to the center line Q of the secondary display region AA2) along the first direction X. And, an arrangement position of the second end of the first connecting line 1511 in the a-th connecting line group is aligned with an arrangement position of the second end of the first compensation line 1611 in the a-th compensation line group (the ends of the first compensation lines 1611 away from the center line Q of the secondary display region AA2) along the first direction X.

In some other examples, the arrangement position of the first connecting line 1511 in the a-th connecting line group along the first direction X may be partially aligned with the arrangement position of the first compensation line 1611 in the a-th compensation line group along the first direction X.

In some examples, an arrangement position of the second connecting line 1512 in the a-th connecting line group along the first direction X is at least partially aligned with an arrangement position of the second compensation line 1612 in the a-th compensation line group along the first direction X.

In some examples, the arrangement position of the second connecting line 1512 in the a-th connecting line group along the first direction X may be completely aligned with the arrangement position of the second compensation line 1612 in the a-th compensation line group along the first direction X (see FIGS. 10 to 12). In this case, an arrangement position of the first end of the second connecting line 1512 in the a-th connecting line group is aligned with an arrangement position of the first end of the second compensation line 1612 in the a-th compensation line group (the ends of the second compensation lines 1612 proximate to the center line Q of the secondary display region AA2) along the first direction X. In addition, an arrangement position of the second end of the second connecting line 1512 in the a-th connecting line group is aligned with an arrangement position of the second end of the second compensation line 1612 in the a-th compensation line group (the ends of the second compensation lines 1612 away from the center line Q of the secondary display region AA2) along the first direction X.

In some other examples, the arrangement position of the second connecting line 1512 in the a-th connecting line group along the first direction X may be partially aligned with the arrangement position of the second compensation line 1612 in the a-th compensation line group along the first direction X.

It can be understood that the arrangement position of the first connecting line 1511 in the a-th connecting line group along the first direction X is set to be at least partially aligned with the arrangement position of the first compensation line 1611 in the a-th compensation line group along the first direction X, and the arrangement position of the second connecting line 1512 in the a-th connecting line group along the first direction X is set to be at least partially aligned with the arrangement position of the second compensation line 1612 in the a-th compensation line group along the first direction X, which may improve the regularity of the arrangement of the connecting lines 151 and the compensation lines 161, thereby improving the processing convenience of the display panel 100.

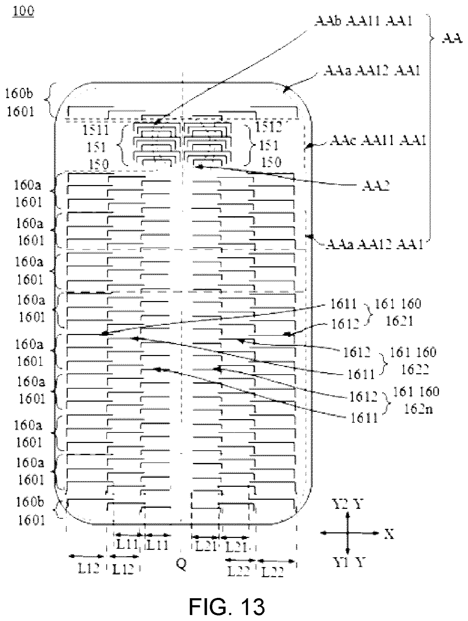

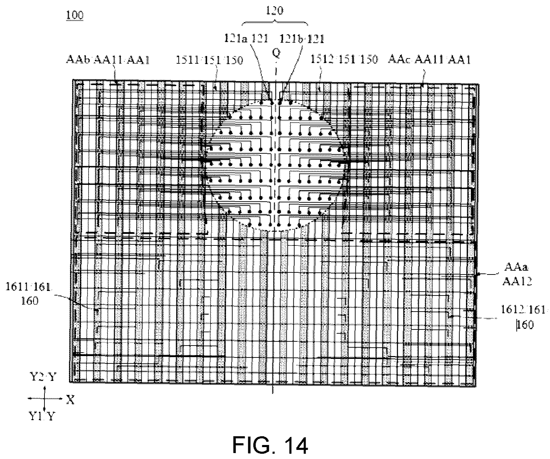

FIG. 13 is a structural diagram of yet another display panel, in accordance with some embodiments; and FIG. 14 is a partial structural diagram of a display panel, in accordance with yet some other embodiments. It will be noted that, since FIG. 14 only shows a partial structure of the display panel 100, the first sub-region AAa of FIG. 14 only shows a part of the line segments of a part of the compensation lines 161.

It can be seen from the above that the at least one first compensation unit 160a is located in the first sub-region AAa, and the first compensation unit 160a may include n compensation line groups 160. Therefore, in a case where the compensation line group 160 includes the first compensation lines 1611 and the second compensation lines 1612, the first sub-region AAa may be provided with a plurality of first compensation lines 1611 and a plurality of second compensation lines 1612 therein.

In some examples, as shown in FIGS. 13 and 14, a plurality of first compensation lines 1611 located in a same first sub-region AAa may be arranged at intervals along the first direction; and/or, a plurality of second compensation lines 1612 located in a same first sub-region AAa may be arranged at intervals along the first direction.

It can be understood that the intervals between the plurality of first compensation lines 1611 located in the same first sub-region AAa may be the same or different, and the intervals between the plurality of second compensation lines 1612 located in the same first sub-region AAa may be the same or different. In this way, the arrangement flexibility of the plurality of compensation lines 161 (including the first compensation lines 1611 and the second compensation lines 1612) in the first sub-region AAa may be improved, so as to satisfy different usage requirements.

The plurality of first compensation lines 1611 located in the same first sub-region AAa is set to be arranged at intervals along the first direction, which may increase distance(s) between the plurality of first compensation lines 1611 located in the same first sub-region AAa along the first direction X and reduce the risk of short circuit between two adjacent first compensation lines 1611. The plurality of second compensation lines 1612 located in the same first sub-region AAa is set to be arranged at intervals along the first direction X, which may increase distance(s) between the plurality of second compensation lines 1612 located in the same first sub-region AAa along the first direction X, and reduce the risk of short circuit between two adjacent second compensation lines 1612.

In addition, the above-mentioned arrangement may further improve the distribution uniformity of the plurality of first compensation lines 1611 and the plurality of second compensation lines 1612 located in the same first sub-region AAa along the first direction X, so that the etching uniformity of the transfer layer 1302 is improved, and the pattern on the conductive layer 130 (e.g., the transfer layer 1302) may be more uniform, and the consistency of the parasitic capacitances formed between the transfer layer 1302 and other conductive layers 130 at different positions is improved, thereby improving the display effect of the display panel 100.

In some examples, as shown in FIG. 13, in a case where the plurality of first compensation lines 1611 located in the same first sub-region AAa are arranged at intervals along the first direction X, intervals between first ends or second ends of the plurality of first compensation lines 1611 located in the same first sub-region AAa along the first direction X are the same. In a case where the plurality of second compensation lines 1612 located in the same first sub-region AAa are arranged at intervals along the first direction X, intervals between first ends or second ends of the plurality of second compensation lines 1612 located in the same first sub-region AAa along the first direction X are the same.

For example, a first end of the compensation line 161 (including the first compensation line 1611 and the second compensation line 1612) is an end of the compensation line 161 proximate to the center line Q of the secondary display region AA2; a second end of the compensation line 161 (including the first compensation line 1611 and the second compensation line 1612) is an end of the compensation line 161 away from the center line Q of the secondary display region AA2.

It can be understood that the intervals between the first ends or the second ends of the plurality of first compensation lines 1611 located in the same first sub-region AAa along the first direction X are the same, that is, the intervals between the first ends of the plurality of first compensation lines 1611 located in the same first sub-region AAa along the first direction X are the same (see first distances L11 in FIG. 13), or the intervals between the second ends of the plurality of first compensation lines 1611 located in the same first sub-region AAa along the first direction X are the same (see second distances L12 in FIG. 13). It can be understood that the first distance L11 and the second distance L12 may be equal or unequal.

The intervals between the first ends or the second ends of the plurality of second compensation lines 1612 located in the same first sub-region AAa along the first direction X are the same, that is, the intervals between the first ends of the plurality of second compensation lines 1612 located in the same first sub-region AAa along the first direction X are the same (see third distances L21 in FIG. 13), or, the intervals between the second ends of the plurality of second compensation lines 1612 located in the same first sub-region AAa along the first direction X are the same (see fourth distances L22 in FIG. 13). It can be understood that the third distance L21 and the fourth distance L22 may be equal or unequal.

In a case where the plurality of first compensation lines 1611 located in the same first sub-region AAa are arranged at intervals along the first direction X, the intervals between the first ends or the second ends of the plurality of first compensation lines 1611 located in the same first sub-region AAa along the first direction X are the same, and in a case where the plurality of second compensation lines 1612 located in the same first sub-region AAa are arranged at intervals along the first direction X, the intervals between the first ends or the second ends of the plurality of second compensation lines 1612 located in the same first sub-region AAa along the first direction X are the same, which may improve the regularity of arrangement of the plurality of compensation lines 161 (including the plurality of first compensation lines 1611 and the plurality of second compensation lines 1612) on the conductive layer 130 (e.g., the transfer layer 1302), improve the etching uniformity of the transfer layer 1302, and improve the consistency of parasitic capacitances formed between the transfer layer 1302 and other conductive layers 130 at different positions, thereby improving the display effect of the display panel 100.

Furthermore, the above-mentioned arrangement may further improve the regularity of arrangement of the plurality of first compensation lines 1611 and the plurality of second compensation lines 1612, thereby improving the processing convenience of the display panel 100.

In some examples, taking the display panel 100 including 1080 columns of pixel circuits 140 as an example, the first ends of the plurality of first compensation lines 1611 located in the same first sub-region AAa may be spaced apart by 6 columns of pixel circuits 140 along the first direction X, and the first ends of the plurality of second compensation lines 1612 located in the same first sub-region AAa may also be spaced apart by 6 columns of pixel circuits 140 along the first direction X. The embodiments of the present disclosure do not further limit the intervals between the first ends of plurality of first compensation lines 1611 located in the same first sub-region AAa along the first direction X, and the intervals between the first ends of plurality of second compensation lines 1612 located in the same first sub-region AAa along the first direction X.

It can be understood that the intervals (see the first distances L11 in FIG. 13) between the first ends of plurality of first compensation lines 1611 located in the same first sub-region AAa along the first direction X and the intervals (see the third distances L21 in FIG. 13) between the first ends of plurality of second compensation lines 1612 along the first direction X may be the same or different. The intervals between the second ends of plurality of first compensation lines 1611 located in the same first sub-region AAa along the first direction X (see the third distance L12 in FIG. 13) and the intervals between the second ends of plurality of second compensation lines 1612 along the first direction X (see the fourth distance L22 in FIG. 13) may be the same or different.

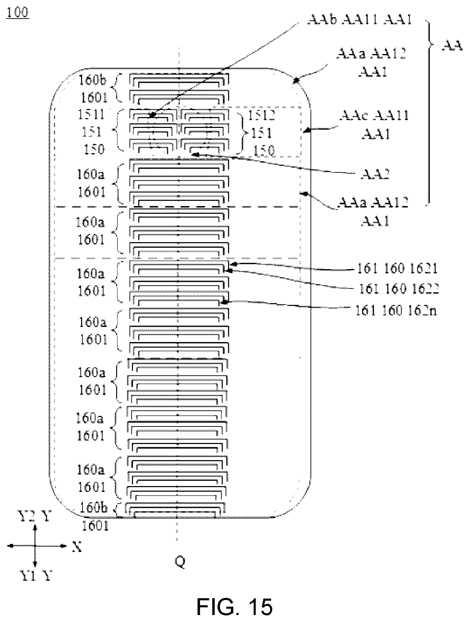

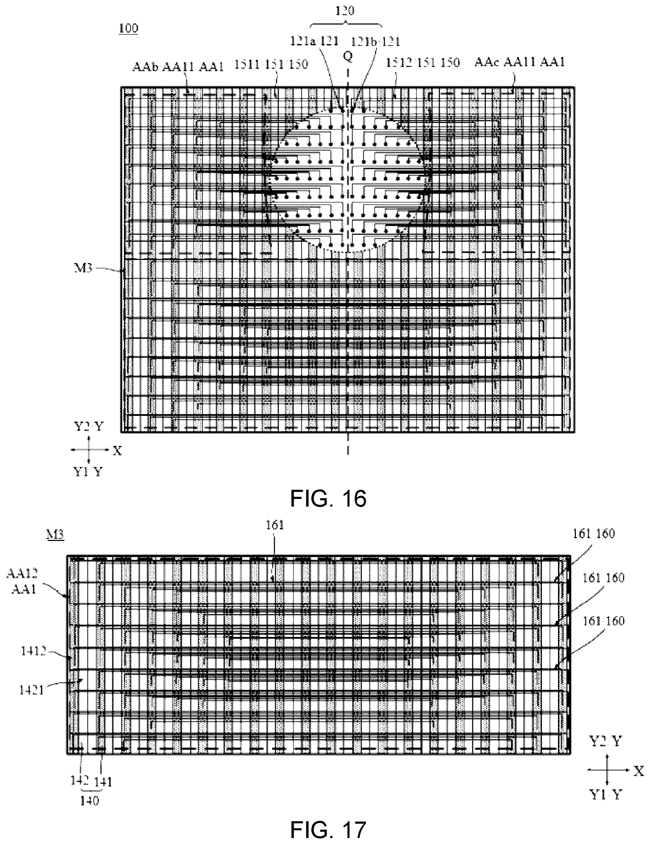

FIG. 15 is a structural diagram of yet another display panel, in accordance with some embodiments; FIG. 16 is a partial structural diagram of a display panel, in accordance with yet some other embodiments; and FIG. 17 is an enlarged partial view of the M3 region in FIG. 16.

As can be seen from the above, in some examples, the at least one compensation line group 160 may include the first compensation line(s) 1611 and the second compensation line(s) 1612.

In some other examples, as shown in FIGS. 15 and 16, the at least one compensation line group 160 includes a single compensation line 161.

It can be understood that in a case where at least one compensation line group 160 includes the single compensation line 161, a sum of the number of pixel circuits 140 through which the first connecting line 1511 in the a-th connecting line group 150 passes along the first direction X and the number of pixel circuits 140 through which the second connecting line 1512 in the a-th connecting line group 150 passes along the first direction X is less than or equal to the number of pixel circuits 140 through which the single compensation line 161 in the a-th compensation line group 160 passes along the first direction X.

In some examples, a sum of the length of the first connecting line 1511 in the a-th connecting line group 150 along the first direction X and the length of the second connecting line 1512 in the a-th connecting line group 150 along the first direction X is less than or equal to a length of the single compensation line 161 in the a-th compensation line group 160 along the first direction X, so that the number of pixel circuits 140 through which the first connecting line 1511 in the a-th connecting line group 150 passes along the first direction X and the number of pixel circuits 140 through which the second connecting line 1512 in the a-th connecting line group 150 passes along the first direction X may be less than or equal to the number of pixel circuits 140 through which the single compensation line 161 in the a-th compensation line group 160 passes along the first direction X.

In some examples, as shown in FIGS. 16 and 17, an arrangement position of the a-th connecting line group along the first direction X is at least partially aligned with an arrangement position of the a-th compensation line group along the first direction X.

In some examples, the arrangement position of the a-th connecting line group along the first direction X may be completely aligned with the arrangement position of the a-th compensation line group along the first direction X (see FIGS. 15 to 17). In this case, the arrangement position of the second end of the first connecting line 1511 in the a-th connecting line group is aligned with the arrangement position of an end of the compensation line 161 along the first direction X; the arrangement position of the second end of the second connecting line 1512 in the a-th connecting line group is aligned with the arrangement position of other end of the compensation line 161 along the first direction X.

In some other examples, the arrangement position of the a-th connecting line group along the first direction X may be partially aligned with the arrangement position of the a-th compensation line group along the first direction X.

It can be understood the arrangement position of the a-th connecting line group along the first direction X is set to be at least partially aligned with the arrangement position of the a-th compensation line group along the first direction X, which may improve the regularity of the arrangement of the compensation line 161 and improve the processing convenience of the display panel 100.

In a case where the compensation line group 160 includes the first compensation line 1611 and the second compensation line 1612, at least one end of the first compensation line 1611 is electrically connected to the redundant pixel circuit 1412, and at least one end of the second compensation line 1612 is electrically connected to the redundant pixel circuit 1412.

For example, an end of the first compensation line 1611 may be electrically connected to the redundant pixel circuit 1412, and another end of the first compensation line 1611 may be suspended. An end of the second compensation line 1612 may be electrically connected to the redundant pixel circuit 1412, and another end of the second compensation line 1612 may be suspended.

In a case where the compensation line group 160 includes one compensation line 161, in some examples, at least one end of the compensation line 161 may be electrically connected to the redundant pixel circuit 1412; in some other examples, the compensation line 161 may also be electrically connected to the second voltage signal line VSS. The following will be illustrated by taking an example in which the compensation line group 160 includes one compensation line 161, and the compensation line 161 is electrically connected to the second voltage signal line VSS.

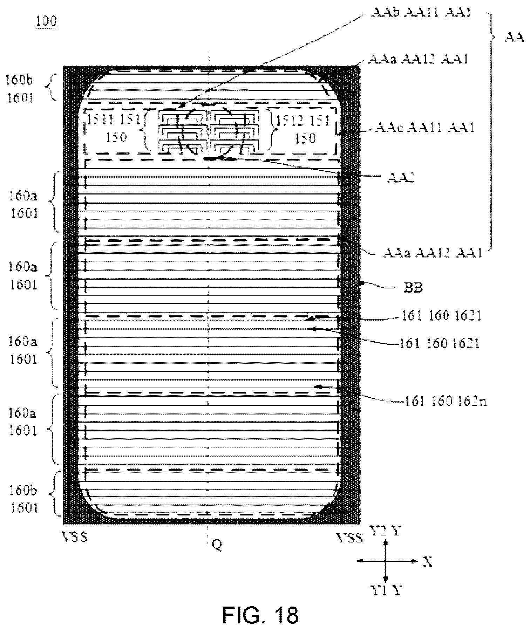

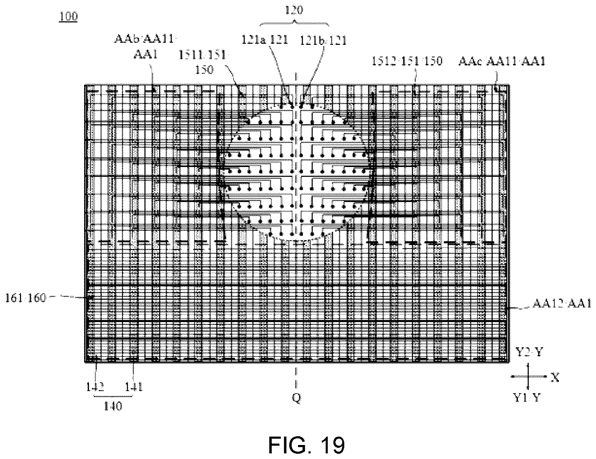

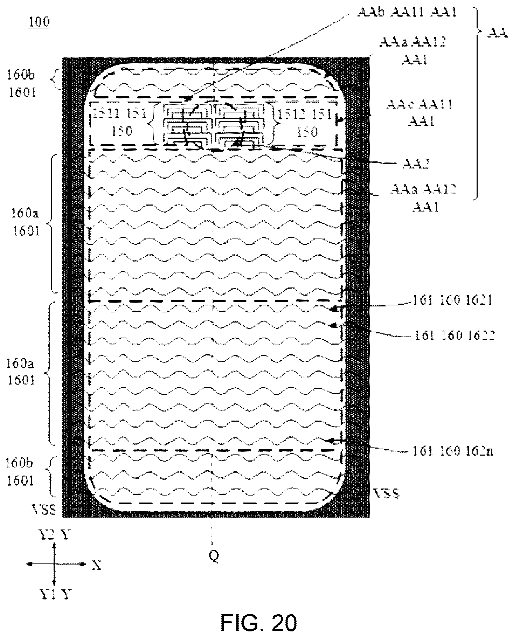

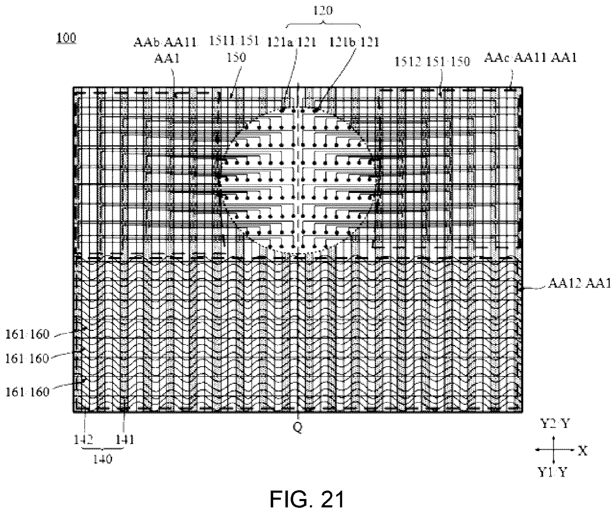

FIG. 18 is a structural diagram of yet another display panel, in accordance with some embodiments; FIG. 19 is a partial structural diagram of a display panel, in accordance with yet some other embodiments; FIG. 20 is a structural diagram of yet another display panel, in accordance with some embodiments; and FIG. 21 is a partial structural diagram of a display panel, in accordance with yet some other embodiments.

As shown in FIG. 18, the display panel 100 may further include a peripheral region BB, and the peripheral region BB at least partially surrounds the display region AA.

It can be understood that the peripheral region BB may completely surround the display region AA, and the peripheral region BB may also partially surround the display region AA.

As can be seen from the above, the display panel 100 further includes the second voltage signal line VSS, and the second voltage signal line VSS is located in the peripheral region BB. At least one end of the at least one compensation line 161 extends to the peripheral region BB and is electrically connected to the second voltage signal line VSS.

It can be understood that in a case where the compensation line group 160 includes one compensation line 161, a part of the line segments of the compensation line 161 may be located in the first sub-region AAa of the second main display region AA12, and another part of the line segments of the compensation line 161 may extend to the peripheral region BB. For example, an end of the compensation line 161 may be electrically connected to the second voltage signal line VSS, or both ends of the compensation line 161 may be electrically connected to the second voltage signal line VSS.

The at least one end of the at least one compensation line 161 is set to extend to the peripheral region BB and be electrically connected to the second voltage signal line VSS, so that the second voltage signal line VSS is capable of providing a constant voltage signal for the compensation line 161, and the compensation line 161 is capable of compensating for the loading of the pixel circuits 140 located in the second main display region AA12, thereby improving the brightness uniformity of the display panel 100.

In some examples, the second voltage signal line VSS is located at least on two sides of the display region AA along the first direction X. An end of the at least one compensation line 161 is located on a side of the display region AA along the first direction, and is electrically connected to the second voltage signal line VSS located in the peripheral region BB. Another end of the at least one compensation line 161 is located on another side of the display region along the first direction X, and is electrically connected to the second voltage signal line VSS located in the peripheral region BB.

In some examples, as shown in FIG. 18, the peripheral region BB is arranged around the display region AA, so that the peripheral region BB may be located on both sides of the display region AA along the first direction X, and the peripheral region BB may be located on both sides of the display region AA along the second direction Y. For example, the second voltage signal line VSS may include a first partial line segment, a second partial line segment and a third partial line segment. The first partial line segment and the second partial line segment are located on both sides of the display region AA along the first direction X. An end of the third partial line segment is electrically connected to the first partial line segment, and another end of the third partial line segment is electrically connected to the second partial line segment.

In some examples, the third partial line segment may be located on a side of the display region AA along the first sub-direction Y1 (i.e., located at an upper edge of the display panel 100). In some other examples, the third partial line segment may also be located on a side of the display region AA along the second sub-direction Y2 (i.e., located at a lower edge of the display panel 100).

In some examples, an end of the at least one compensation line 161 is located on a side of the display region AA along the first direction and is electrically connected to the second voltage signal line VSS located in the peripheral region BB (e.g., the first partial line segment of the second voltage signal line VSS), and another end of the at least one compensation line 161 is located on another side of the display region along the first direction X and is electrically connected to the second voltage signal line VSS located in the peripheral region BB (e.g., the second partial line segment of the second voltage signal line VSS).

Such an arrangement enables the second voltage signal line VSS to provide a constant voltage signal to the compensation line 161, so that the compensation line 161 may compensate for the loading of the pixel circuit 140 in the second main display region AA12, thereby improving the brightness uniformity of the display panel 100.

In some examples, as shown in FIGS. 19 and 20, shapes of the line segments of the at least one compensation line 161 located in the first sub-region AAa include at least one of a straight shape and a wavy shape.

In some examples, as shown in FIGS. 18 and 19, the shapes of the line segments of the compensation line 161 located in the first sub-region AAa may all be straight; in some other examples, as shown in FIGS. 20 and 21, the shapes of the line segments of the compensation lines 161 located in the first sub-region AAa may all be wavy. In some other examples, the shapes of the line segments of the compensation line 161 located in the first sub-region AAa may also be partially straight and partially wavy.

It can be understood that in a case where the shapes of the line segments of the compensation line 161 located in the first sub-region AAa are wavy, the shapes of the line segments of the compensation line 161 located in the first sub-region AAa may be regular wavy, irregular wavy, bow-shaped, etc.

It can be understood that the shapes of the line segments of the at least one compensation line 161 located in the first sub-region AAa are set to include at least one of the straight shape and the wavy shape, which may improve the flexibility of the arrangement of the compensation line 161 and satisfy different usage requirements.

In a case where the shapes of the line segments of the compensation lines 161 in the first sub-region AAa are all wavy, the risk of light irradiating the plurality of compensation lines 161 and diffracting, resulting in colored spots on the display panel 100, may be reduced, thereby improving the display performance of the display panel 100.

In some examples, as shown in FIG. 20, the compensation unit 1601 further includes a second compensation unit 160b, and the second compensation unit 160b includes m compensation line groups 160. For example, m is a positive integer, and m is less than n. Along the second direction Y, the second compensation unit 160b is adjacent to the edge of the display panel 100.

In some examples, a first sub-region AAa proximate to the edge of the display panel 100 along the second direction Y has a small width along the second direction Y and cannot accommodate the n compensation line groups 160 in the first compensation unit 160a. Therefore, the compensation unit 1601 is set to further include the second compensation unit 160b, the second compensation unit 160b includes m compensation line groups 160, and m is a positive integer and is less than n, so that the second compensation unit 160a may be located in the first sub-region AAa adjacent to the display panel 100 along the second direction Y, that is, along the second direction Y, the second compensation unit 160b may be adjacent to the edge of the display panel 100.

In this way, the second compensation unit 160b is capable of compensating for the loading of the pixel circuits 140 adjacent to the edge of the display panel 100 along the second direction Y, so that the brightness of the position proximate to the edge of the display panel 100 along the second direction Y may be the same or approximately the same as the brightness of the position proximate to the center of the display panel 100 along the second direction Y, thereby improving the brightness uniformity of the display panel 100.

In some examples, an arrangement position of the compensation lines 161 of the compensation line group 160 in the second compensation unit 160b along the first direction X is at least partially aligned with an arrangement position of the connecting lines 151 of the connecting line group 150 along the first direction X. In some other examples, the compensation lines 161 in the second compensation unit 160b may also be arranged at intervals along the first direction X. It can be understood that the embodiments of the present disclosure do not further limit the arrangement of the compensation lines 161 in the second compensation unit 160b.

As can be seen from the above, in some examples, the number of compensation line groups 160 in the first compensation unit 160a is equal to the number of connecting line groups 150 (both are n). Furthermore, the number of pixel circuits 140 through which the connecting lines 151 in the a-th connecting line group 150 pass along the first direction X is less than or equal to the number of pixel circuits 140 through which the compensation lines 161 in the a-th compensation line group 160 pass along the first direction X. For example, a is any positive integer between 1 and n.

In some other examples, an overlapping area between the pixel circuits 140 through which the connecting line 151 in the a-th connecting line group passes along the first direction X and the connecting line 151 in the a-th connecting line group is less than or equal to an overlapping area between the pixel circuits 140 through which the compensation line 161 in the a-th compensation line group passes along the first direction X and the compensation line 161 in the a-th compensation line group. That is, an overlapping area between the pixel circuits 140 through which the connecting line 151 in the a-th connecting line group passes along the first direction X and the connecting line 151 is less than or equal to an overlapping area between the pixel circuits 140 through which the compensation line 161 in the a-th compensation line group passes along the first direction X and the compensation line 161.

It can be understood that a is any positive integer between 1 and n, so that an overlapping area between the pixel circuits 140 through which the connecting line 151 in the first connecting line group passes along the first direction X and the connecting line 151 is less than or equal to an overlapping area between the pixel circuits 140 through which the compensation line 161 in the first compensation line group passes along the first direction X and the compensation line 161. An overlapping area between the pixel circuits 140 through which the connecting line 151 in the second connecting line group passes along the first direction X and the connecting line 151 is less than or equal to an overlapping area between the pixel circuits 140 through which the compensation line 161 in the second compensation line group passes along the first direction X and the compensation line 161. Similar, an overlapping area between the pixel circuits 140 through which the connecting line 151 in the n-th connecting line group passes along the first direction X and the connecting line 151 is less than or equal to an overlapping area between the pixel circuits 140 through which the compensation line 161 in the n-th compensation line group passes along the first direction X and the compensation line 161.

With such an arrangement, the coupling generated between the first compensation unit 160a and the pixel circuits 140 in the second main display region AA12 may be the same or approximately the same as the coupling generated between the connecting line group 150 and the pixel circuits 140 located in the first main display region AA11. In this way, the first compensation unit 160a is capable of reducing the difference between the loading of the pixel circuits 140 located in the second main display region AA12 and the loading of the pixel circuits 140 located in the first main display region AA11, so as to improve the horizontal hole mura of the display panel 100, and improve the brightness uniformity of different positions of the display panel 100, thereby improving the display performance of the display panel 100.

It can be understood that overlapping areas between the pixel circuits 140 and the connecting lines 151 in different connecting line groups 150 may be the same or different. Overlapping areas between the pixel circuits 140 and the compensation lines 161 in different compensation line groups 160 may be the same or different.

In some examples, in a case where the compensation line group 160 includes a first compensation line 1611 and a second compensation line 1612, an overlapping area between the pixel circuits 140 through which the first connecting line 1511 in the a-th connecting line group passes along the first direction X and the first connecting line 1511 in the a-th connecting line group is the same as an overlapping area between the pixel circuits 140 through which the first compensation line 1611 in the a-th compensation line group passes along the first direction X and the first compensation lines 1611 in the a-th compensation line group. Furthermore, an overlapping area between the pixel circuits 140 through which the second connecting line 1512 in the a-th connecting line group passes along the first direction X and the second connecting line 1512 in the a-th connecting line group is the same as an overlapping area between the pixel circuits 140 through which the second compensation line 1612 in the a-th compensation line group passes along the first direction X and the second compensation line 1612 in the a-th compensation line group.

That is, an overlapping area between the pixel circuits 140 through which the first connecting line 1511 in the a-th connecting line group passes along the first direction X and the first connecting line 1511 is the same as an overlapping area between the pixel circuits 140 through which the first compensation line 1611 in the a-th compensation line group passes along the first direction X and the first compensation line 1611. In addition, an overlapping area between the pixel circuits 140 through which the second connecting line 1512 in the a-th connecting line group passes along the first direction X and the second connecting line 1512 is the same as an overlapping area between the pixel circuits 140 through which the second compensation line 1612 in the a-th compensation line group passes along the first direction X and the second compensation line 1612.

It can be understood that a is any positive integer between 1 and n. In this way, an overlapping area between the pixel circuits 140 through which the first connecting line 1511 in the first connecting line group passes along the first direction X and the first connecting line 1511 is the same as an overlapping area between the pixel circuits 140 through which the first compensation line 1611 in the first compensation line group passes along the first direction X and the first compensation line 1611. In addition, an overlapping area between the pixel circuits 140 through which the second connecting line 1512 in the first connecting line group passes along the first direction X and the second connecting line 1512 is the same as an overlapping area between the pixel circuits 140 through which the second compensation line 1612 in the first compensation line group passes along the first direction X and the second compensation line 1612. An overlapping area between the pixel circuits 140 through which the first connecting line 1511 in the second connecting line group passes along the first direction X and the first connecting line 1511 is the same as an overlapping area between the pixel circuits 140 through which the first compensation line 1611 in the second compensation line group passes along the first direction X and the first compensation line 1611. In addition, an overlapping area between the pixel circuits 140 through which the second connecting line 1512 in the second connecting line group passes along the first direction X and the second connecting line 1512 is the same as an overlapping area between the pixel circuits 140 through which the second compensation line 1612 in the second compensation line group passes along the first direction X and the second compensation line 1612. Similar, an overlapping area between the pixel circuits 140 through which the first connecting line 1511 in the n-th connecting line group passes along the first direction X and the first connecting line 1511 is the same as an overlapping area between the pixel circuits 140 through which the first compensation line 1611 in the n-th compensation line group passes along the first direction X and the first compensation line 1611. In addition, an overlapping area between the pixel circuits 140 through which the second connecting line 1512 in the n-th connecting line group passes along the first direction X and the second connecting line 1512 is the same as an overlapping area between the pixel circuits 140 through which the second compensation line 1612 in the n-th compensation line group passes along the first direction X and the second compensation line 1612.

With such an arrangement, the first compensation lines 1611 are capable of compensating for the influence of the first connecting lines 1511 on the loading of the pixel circuits 140 located in the first main display region AA11, and the second compensation lines 1612 are capable of compensating for the influence of the second connecting lines 1512 on the loading of the pixel circuits 140 located in the first main display region AA11, so that the compensation lines 161 (including the first compensation lines 1611 and the second compensation lines 1612) may reduce the difference between the loading of the pixel circuits 140 located in the first sub-regions AAa and the loading of the pixel circuits 140 located in the first main display region AA11, thereby improving the brightness uniformity of different positions of the display panel 100, improving the lateral hole mura of the display panel 100, and improving the display performance of the display panel 100.

Moreover, the above-mentioned arrangement may further improve the regularity of the arrangement of the first compensation lines 1611 and the second compensation lines 1612, improve the etching uniformity of the transfer layer 1302, and improve the consistency of the parasitic capacitances formed between the transfer layer 1302 and other conductive layers 130 at different positions, thereby improving the display effect of the display panel 100.

In summary, the embodiments of the present disclosure have at least the following beneficial effects.

In the embodiments of the present disclosure, by providing the plurality of connecting line groups 150, the plurality of first light-emitting devices 121 located in the secondary display region AA2 may be electrically connected to the plurality of first driving pixel circuits 1411 located in the first main display region AA11, so that the first driving pixel circuits 1411 may drive the first light-emitting devices 121 to emit light.

In addition, the plurality of conductive layers 130 includes the plurality of compensation line groups 160, and the plurality of compensation line groups 160 are arranged at intervals along the second direction Y, and the compensation line 161 in the compensation line group 160 extends along the first direction X, so that the arrangement of the compensation line group 160 can be the same as the arrangement of the connecting line group 150, and the extending direction of the compensation line 161 can be the same as the extending direction of the connecting line 151.

The compensation line 161 is electrically connected to the constant voltage signal, so that the compensation line 161 can be coupled to the pixel circuit 140 (e.g., the redundant pixel circuit 1412 or the second driving pixel circuit 1421) located in the second main display region AA12. The number of compensation line groups 160 in the first compensation unit 160a is the same as the number of connecting line groups 150 (both are n), and the number of pixel circuits 140 through which the connecting lines 151 in the a-th connecting line group 150 pass along the first direction X may be less than or equal to the number of pixel circuits 140 through which the compensation lines 161 in the a-th compensation line group 160 pass along the first direction X, so that the coupling generated between the first compensation unit 160a and the pixel circuits 140 in the second main display region AA12 may be the same or substantially the same as the coupling generated between the connecting line group 150 and the pixel circuits 140 located in the first main display region AA11. In this way, the first compensation unit 160a is capable of reducing the difference between the loading of the pixel circuit 140 located in the second main display region AA12 and the loading of the pixel circuit 140 located in the first main display region AA11, so as to improve the horizontal hole mura of the display panel 100, and improve the brightness uniformity of different positions of the display panel 100, thereby improving the display performance of the display panel 100.

The above are only specific embodiments of the present disclosure, but the scope of protection of the present disclosure is not limited thereto, and any person skilled in the art may conceive of variations or replacements within the technical scope of the present disclosure, which shall fall within the protection scope of the present disclosure. Therefore, the protection scope of the present disclosure should be determined by the protection scope of the claims.

## Claims

1. A display panel, comprising a display region; wherein the display region includes a main display region and a secondary display region; the main display region at least partially surrounds the secondary display region, and the main display region includes a first main display region and a second main display region; the first main display region is located on both sides of the secondary display region along a first direction, and the second main display region is located on at least one side of the secondary display region along a second direction; the first direction intersects with the second direction; and the display panel comprises:
a substrate;
a plurality of light-emitting devices located on a side of the substrate, the plurality of light-emitting devices including a plurality of first light-emitting devices located in the secondary display region; and
a plurality of conductive layers stacked between the substrate and the plurality of light-emitting devices, the plurality of conductive layers including a plurality of pixel circuits, a plurality of connecting line groups and a plurality of compensation line groups; wherein
the plurality of pixel circuits are located in the main display region; the plurality of pixel circuits are arranged in multiple columns along the first direction, and the plurality of pixel circuits are arranged in multiple rows along the second direction; at least one column of the multiple columns of pixel circuits includes first driving pixel circuits located in the first main display region;
the plurality of connecting line groups are arranged at intervals along the second direction; at least one of the plurality of connecting line groups includes at least two connecting lines, and the at least two connecting lines are arranged at intervals along the first direction and extend along the first direction; a first end of each of the at least two connecting lines is located in the secondary display region and is electrically connected to a first light-emitting device, and a second end of each of the at least two connecting lines extends to the first main display region and is electrically connected to a first driving pixel circuit; a number of the connecting line groups is n, and the n connecting line groups include a first connecting line group, a second connecting line group, ..., and an n-th connecting line group;
the plurality of compensation line groups are arranged at intervals along the second direction; at least one of the plurality of compensation line groups includes at least one compensation line; the at least one compensation line extends along the first direction, and the at least one compensation line is configured to be electrically connected to a constant voltage signal; the plurality of compensation line groups constitute compensation units, and the compensation units include first compensation units; a first compensation unit includes a first compensation line group, a second compensation line group, ..., and an n-th compensation line group; and
a number of pixel circuits through which connecting lines in an a-th connecting line group pass along the first direction is less than or equal to a number of pixel circuits through which compensation lines in an a-th compensation line group pass along the first direction; wherein n is a positive integer, and a is any positive integer between 1 and n.

2. The display panel according to claim 1, wherein the second main display region includes a plurality of first sub-regions; the plurality of first sub-regions are adjacently arranged along the second direction, and a first sub-region is arranged adjacent to the first main display region along the second direction; and
a number of the compensation line groups is greater than the number of the connecting line groups, and at least one first compensation unit is located in a same first sub-region.

3. The display panel according to claim 2, wherein the first main display region includes a second sub-region and a third sub-region, the second sub-region is located on a side of the secondary display region along the first direction, and the third sub-region is located on a side of the secondary display region away from the second sub-region along the first direction; and
the at least one connecting line group includes first connecting line(s) and second connecting line(s); a second end of a first connecting line is located in the second sub-region, and a second end of a second connecting line is located in the third sub-region.

4. The display panel according to claim 3, wherein the at least one compensation line group includes a first compensation line and a second compensation line, and the first compensation line and the second compensation line are arranged at intervals along the first direction; and
a number of pixel circuits through which the first connecting line in the a-th connecting line group passes along the first direction is the same as a number of pixel circuits through which the first compensation line in the a-th compensation line group passes along the first direction; and a number of pixel circuits through which the second connecting line in the a-th connecting line group passes along the first direction is the same as a number of pixel circuits through which the second compensation line in the a-th compensation line group pass along the first direction.

5. The display panel according to claim 4, wherein an arrangement position of the first connecting line in the a-th connecting line group along the first direction is at least partially aligned with an arrangement position of the first compensation line in the a-th compensation line group along the first direction; and/or
an arrangement position of the second connecting line in the a-th connecting line group along the first direction is at least partially aligned with an arrangement position of the second compensation line in the a-th compensation line group along the first direction.

6. The display panel according to claim 4, wherein
a plurality of first compensation lines located in the same first sub-region are arranged at intervals along the first direction; and/or a plurality of second compensation lines located in the same first sub-region are arranged at intervals along the first direction.

7. The display panel according to claim 6, wherein in the case where the plurality of first compensation lines located in the same first sub-region are arranged at intervals along the first direction, first ends or second ends of the plurality of first compensation lines located in the same first sub-region have same intervals along the first direction; and
in the case where the plurality of second compensation lines located in the same first sub-region are arranged at intervals along the first direction, first ends or second ends of the plurality of the second compensation lines located in the same second sub-region have same intervals along the first direction.

8. The display panel according to claim 3, wherein the at least one compensation line group includes one compensation line; and
an arrangement position of the a-th connecting line group along the first direction is at least partially aligned with an arrangement position of the a-th compensation line group along the first direction.

9. The display panel according to any one of claims 3 to 8, wherein the at least one column of pixel circuits further includes redundant pixel circuits located in the second main display region; along the second direction, the redundant pixel circuits and the first driving pixel circuits are arranged in a column; at least one end of the at least one compensation line is electrically connected to a redundant pixel circuit.

10. The display panel according to claim 9, wherein a pixel circuit includes a second light-emitting control transistor and a second reset transistor; a second electrode of the second light-emitting control transistor is electrically connected to a second electrode of the second reset transistor, and a connection node between the second electrode of the second light-emitting control transistor and the second electrode of the second reset transistor is a fourth node; the second end of the connecting line is electrically connected to the fourth node of the first driving circuit; and
the at least one end of the at least one compensation line is electrically connected to the fourth node of the redundant pixel circuit.

11. The display panel according to claim 9 or 10, wherein the redundant pixel circuits and the first driving pixel circuits are arranged to form a first column of pixel circuits; the plurality of pixel circuits further include second driving pixel circuits, and the second driving pixel circuits are arranged to form a second column of pixel circuits along the second direction; the first column of pixel circuits and the second column of pixel circuits are alternately arranged along the first direction; and
the plurality of light-emitting devices further include second light-emitting devices, and the second light-emitting devices are located in the main display region and electrically connected to the second driving pixel circuits.

12. The display panel according to any one of claims 3 to 8, further comprising a peripheral region; wherein the peripheral region at least partially surrounds the display region; the display panel further comprises a second voltage signal line, and the second voltage signal line is located in the peripheral region; and
at least one end of the at least one compensation line extends to the peripheral region and is electrically connected to the second voltage signal line.

13. The display panel according to claim 12, wherein the second voltage signal line is located at least on both sides of the display region along the first direction; and
an end of the at least one compensation line is located on a side of the display region along the first direction and is electrically connected to the second voltage signal line located in the peripheral region, and another end of the at least one compensation line is located on another side of the display region along the first direction and is electrically connected to the second voltage signal line located in the peripheral region.

14. The display panel according to claim 12 or 13, wherein a shape of line segments of the at least one compensation line located in the first sub-region includes at least one of a straight shape and a wavy shape.

15. The display panel according to any one of claims 3 to 14, wherein the secondary display region includes a center line extending through a center of the secondary display region along the second direction;
the plurality of first light-emitting devices include a plurality of first first light-emitting devices and a plurality of second first light-emitting devices, and the plurality of first first light-emitting devices and the plurality of second first light-emitting devices are located on both sides of the center line of the secondary display region along the first direction; and
a plurality of first connecting lines are electrically connected to the plurality of first first light-emitting devices in a one-to-one correspondence, and a plurality of second connecting lines are electrically connected to the plurality of second first light-emitting devices in a one-to-one correspondence.

16. The display panel according to any one of claims 3 to 15, wherein
the first connecting line(s) include a first first connecting line and a second first connecting line; a distance between a first end of the first first connecting line and an edge of the secondary display region is greater than a distance between a first end of the second first connecting line and the edge of the secondary display region; and a distance between a second end of the first first connecting line and the edge of the secondary display region is greater than a distance between a second end of the second first connecting line and the edge of the secondary display region; and
the second connecting line(s) include a first second connecting line and a second second connecting line; a distance between a first end of the first second connecting line and the edge of the secondary display region is greater than a distance between a first end of the second second connecting line and the edge of the secondary display region; and a distance between a second end of the first second connecting line and the edge of the secondary display region is greater than a distance between a second end of the second second connecting line and the edge of the secondary display region.

17. The display panel according to any one of claims 1 to 16, wherein the compensation units further include a second compensation unit, and the second compensation unit includes m compensation line groups; wherein m is a positive integer, and m is less than n; along the second direction, the second compensation unit is adjacent to an edge of the display panel.

18. The display panel according to any one of claims 1 to 17, wherein the second main display region is located on both sides of the secondary display region along the second direction.

19. The display panel according to any one of claims 1 to 18, wherein the plurality of connecting line groups and the plurality of compensation line groups are located in a same conductive layer.

20. A display panel, comprising a display region; wherein the display region includes a main display region and a secondary display region; the main display region at least partially surrounds the secondary display region, and the main display region includes a first main display region and a second main display region; the first main display region is located on both sides of the secondary display region along a first direction, and the second main display region is located on at least one side of the secondary display region along a second direction; the first direction intersects with the second direction; and the display panel comprises:
a substrate;
a plurality of light-emitting devices located on a side of the substrate, the plurality of light-emitting devices including a plurality of first light-emitting devices located in the secondary display region; and
a plurality of conductive layers stacked between the substrate and the plurality of light-emitting devices, the plurality of conductive layers including a plurality of pixel circuits, a plurality of connecting line groups and a plurality of compensation line groups; wherein
the plurality of pixel circuits are located in the main display region; the plurality of pixel circuits are arranged in multiple columns along the first direction, and the plurality of pixel circuits are arranged in multiple rows along the second direction; at least one column of the multiple columns of pixel circuits includes first driving pixel circuits located in the first main display region;
the plurality of connecting line groups are arranged at intervals along the second direction; at least one of the plurality of connecting line groups includes at least two connecting lines, and the at least two connecting lines are arranged at intervals along the first direction and extend along the first direction; a first end of each of the at least two connecting lines is located in the secondary display region and is electrically connected to a first light-emitting device, and a second end of each of the at least two connecting lines extends to the first main display region and is electrically connected to a first driving pixel circuit; a number of the connecting line groups is n, and the n connecting line groups include a first connecting line group, a second connecting line group, ..., and an n-th connecting line group;
the plurality of compensation line groups are arranged at intervals along the second direction; at least one of the plurality of compensation line groups includes at least one compensation line; the at least one compensation line extends along the first direction, and the at least one compensation line is configured to be electrically connected to a constant voltage signal; the plurality of compensation line groups constitute a compensation unit, and the compensation unit includes a first compensation unit; the first compensation unit includes a first compensation line group, a second compensation line group, ..., and an n-th compensation line group; and
an overlapping area between pixel circuits through which a connecting line in an a-th connecting line group passes along the first direction and the connecting line in the a-th connecting line group is less than or equal to an overlapping area between pixel circuits through which a compensation line in an a-th compensation line group passes along the first direction and the compensation line in the a-th compensation line group; wherein n is a positive integer, and a is any positive integer between 1 and n.

21. The display panel according to claim 20, wherein the first main display region includes a second sub-region and a third sub-region, the second sub-region is located on a side of the secondary display region along the first direction, and the third sub-region is located on a side of the secondary display region away from the second sub-region along the first direction; and
the at least one connecting line group includes a first connecting line and a second connecting line; a second end of the first connecting line is located in the second sub-region, and a second end of the second connecting line is located in the third sub-region.

22. The display panel according to claim 21, wherein the at least one compensation line group includes a first compensation line and a second compensation line, and the first compensation line and the second compensation line are arranged at intervals along the first direction; and
an overlapping area between pixel circuits through which the first connecting line in the a-th connecting line group passes along the first direction and the first connecting line in the a-th connecting line group is the same as an overlapping area between pixel circuits through which the first compensation line in the a-th compensation line group passes along the first direction and the first compensation line in the a-th compensation line group; and an overlapping area between pixel circuits through which the second connecting line in the a-th connecting line group passes along the first direction and the second connecting line in the a-th connecting line group is the same as an overlapping area between pixel circuits through which the second compensation line in the a-th compensation line group passes along the first direction and the second compensation line in the a-th compensation line group.

23. A display apparatus, comprising the display panel according to any one of claims 1 to 22.
